(19) Europäisches Patentamt / European Patent Office / Office européen des brevets

(11) **EP 4 209 802 A2**

(12) # EUROPEAN PATENT APPLICATION

(43) Date of publication:
**12.07.2023 Bulletin 2023/28**

(21) Application number: **22191432.8**

(22) Date of filing: **22.08.2022**

(51) International Patent Classification (IPC):
**G01S 7/481** (2006.01)    **G01S 17/89** (2020.01)
**G01S 17/931** (2020.01)    **H01S 5/40** (2006.01)

(52) Cooperative Patent Classification (CPC):
**G01S 7/4817; G01S 17/89; G01S 17/931;**
**H01S 5/4012**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **07.01.2022 KR 20220002956**
             **20.01.2022 KR 20220008526**

(71) Applicant: **Samsung Electronics Co., Ltd.**
**Gyeonggi-do, 16677 (KR)**

(72) Inventors:
• **Park, Junghyun**
**16678, Suwon-si (KR)**
• **Kim, Sunil**
**16678, Suwon-si (KR)**
• **Lee, Minkyung**
**16678, Suwon-si (KR)**
• **Jeong, Byunggil**
**16678, Suwon-si (KR)**

(74) Representative: **Elkington and Fife LLP**
**Prospect House**
**8 Pembroke Road**
**Sevenoaks, Kent TN13 1XR (GB)**

(54) ## DISTANCE INFORMATION ACQUISITION APPARATUS AND ELECTRONIC APPARATUS INCLUDING THE SAME

(57) A distance information acquisition apparatus includes a plurality of light sources configured to emit light of different wavelengths, a beam steering device including a plurality of nano-antennas and configured to form an effective grating and steer a traveling direction of light incident from the plurality of light sources at an angle of incidence by modulating a phase by displacement of the effective grating, a plurality of photodetectors respectively corresponding to the plurality of light sources and configured to detect light that is steered by the beam steering device and reflected from an object, and a processor configured to control the beam steering device to acquire distance information by steering a traveling direction of light.

FIG. 1

**Description**

FIELD OF THE INVENTION

Example embodiments of the present disclosure relate to distance information acquisition apparatuses and electronic apparatuses including the distance information acquisition apparatuses.

BACKGROUND OF THE INVENTION

When radiated or emitted light is reflected or transmitted, a beam scan may be performed in a non-mechanically moving manner, that is, in a non-mechanical method, by adjusting a reflection phase or transmission phase of a light modulation device to have a different phase distribution for each pixel or channel,

The light modulation device is formed in a structure in which resonance occurs to electrically modulate a phase, and an external light source having a wavelength near a resonance wavelength is used for non-mechanical beam steering with the light modulation device. A resonance phenomenon occurs only in a specific wavelength band, and a section in which a phase of transmitted wave or reflected wave is modulated by an external stimulus also occurs only in a specific wavelength band. Since a wavelength band section in which the phase modulation of the light modulation device is possible is relatively narrow, a beam scan is possible with only one wavelength for one light modulation device. Light waves of wavelengths other than a high-phase modulatory wavelength band have poor efficiency because beam steering does not occur well.

SUMMARY OF THE INVENTION

Example embodiments provide distance information acquisition apparatuses having improved resolution by performing beam steering at a different minute angle for each wavelength with respect to a plurality of wavelengths and electronic apparatuses including the same.

Additional aspects will be set forth in part in the description which follows and, in part, will be apparent from the description, or may be learned by practice of example embodiments of the disclosure.

According to an aspect of an example embodiment, there is provided a distance information acquisition apparatus including a plurality of light sources configured to emit light of different wavelengths, a beam steering device including a plurality of nano-antennas and configured to form an effective grating and steer a traveling direction of light incident from the plurality of light sources at an angle of incidence by modulating a phase by displacement of the effective grating, a plurality of photodetectors respectively corresponding to the plurality of light sources and configured to detect light that is steered by the beam steering device and reflected from an object, and a processor configured to control the beam steering device to acquire distance information by steering a traveling direction of light.

At least two light sources from among the plurality of light sources may be configured to emit that is incident on the beam steering device at a same angle of incidence.

At least two light sources from among the plurality of light sources may be configured to emit light that is incident on the beam steering device at different angles of incidence.

The distance information acquisition apparatus may further include a plurality of band-pass filters provided in front of each of the plurality of photodetectors and configured to pass a wavelength band of the emitted light of a corresponding light source among the plurality of light sources.

The beam steering device may be configured to steer the incident light at different beam steering angles based on a wavelength of the incident light.

The beam steering device may further include a reflective layer, an active layer having an optical property that changes based on a control signal, and at least one insulating layer, and wherein the beam steering device may form the effective grating by forming a charge accumulation region or a charge depletion region in the active layer to correspond to the plurality of nano-antennas based on a voltage applied to at least one of the plurality of nano-antennas and the reflective layer.

The light steered by the beam steering device may be first-order diffracted light.

The plurality of nano-antennas may include metal nano-antennas.

Where an incident angle of light emitted from one of the plurality of light sources and incident on the beam steering device and an emission angle of first-order diffracted light emitted from the beam steering device are $\theta_{inc}$ and $\theta_{1st}$, respectively, a wavelength of the incident light is $\lambda_0$, and a first period of the effective grating corresponding to a period of one antenna group including the plurality of nano-antennas is $\Lambda_{SC,1}$, the emission angle of first-order diffracted light emitted from the beam steering device $\theta_{1st}$ may satisfy

$$\theta_{1st} = \sin^{-1}(\sin\theta_{inc} - \frac{\lambda_0}{\Lambda_{SC,1}})$$

Where an incident angle of light emitted from one of the plurality of light sources and incident on the beam steering device and an emission angle of first-order diffracted light emitted from the beam steering device are $\theta_{inc}$ and $\theta_{1st}$, respectively, a wavelength of the incident light is $\lambda_0$, and a first period of the effective grating corresponding to a period of one antenna group including the plurality of nano-antennas and a second period of the effective grating corresponding to a period of a sum of periods of a plurality of pixels having different effective displacements from each other are $\Lambda_{SC,1}$ and $\Lambda_{SC,2}$, respectively, the emission angle of first-order diffracted light emitted from the beam steering device $\theta_{1st}$ may satisfy

$$\theta_{1st} = \sin^{-1}(\sin\theta_{inc} - \frac{\lambda_0}{\Lambda_{SC,1}} + \frac{\lambda_0}{\Lambda_{SC,2}})$$

The beam steering device may include a plurality of pixels, and each of the plurality of pixels may include the plurality of nano-antennas.

Each of the plurality of pixels may include one or more antenna groups, the one or more antenna groups respectively may include the plurality of nano-antennas, and a period of the effective grating may be the same as a period of the one or more antenna groups.

Each of the plurality of pixels may include two or more antenna groups, and control signals of a same pattern are applied to the two or more antenna groups included in a same pixel.

The plurality of pixels may have a one-dimensional array structure or a two-dimensional array structure.

The beam steering device may be provided so that the formation of the effective grating and displacement adjustment of the beam steering device are performed by any one of electrical gating, light stimulation, a heating chemical reaction, a magnetic field, and a mechanical method.

The beam steering device may be configured to operate in regions of extreme ultraviolet, visible light, near infrared, mid-infrared, far-infrared, terahertz (THz), gigahertz (GHz), and radio frequency (RF).

The plurality of light sources may include one of an edge-emitting laser, a vertical cavity surface-emitting laser, a photonic crystal surface-emitting laser, and a laser diode or a combination thereof.

The plurality of photodetectors may include one of silicon photomultipliers (SiPM), avalanche photodiodes (APD), single-photon avalanche photodiodes (SPAD), and a photodetector (PD).

According to another aspect of an example embodiment, there is provided an electronic apparatus including at least one sensor of a distance sensor, a three-dimensional sensor, and a Light Detection and Ranging (LiDAR) sensor, wherein the at least one sensor includes a distance information acquisition apparatus including a plurality of light sources configured to emit light of different wavelengths, a beam steering device including a plurality of nano-antennas and configured to form an effective grating and steer a traveling direction of light incident from the plurality of light sources at an angle of incidence by modulating a phase by displacement of the effective grating, a plurality of photodetectors respectively corresponding to the plurality of light sources and configured to detect light that is steered by the beam steering device and reflected from an object, and a processor configured to control the beam steering device to acquire distance information by steering a traveling direction of light.

The sensor may include the LiDAR sensor implemented in a mobile device. The electronic apparatus may be a mobile depth camera.

The electronic apparatus may further include a mobile depth camera including the at least one sensor.

According to yet another aspect of an example embodiment, there is provided a distance information acquisition apparatus including a plurality of light sources configured to emit light of different wavelengths, a beam steering device including a plurality of nano-antennas and configured to form an effective grating and steer light incident from the plurality of light sources at different beam steering angles based on the different wavelengths by modulating a phase by displacement of the effective grating, a plurality of photodetectors respectively corresponding to the plurality of light sources and configured to detect light that is steered by the beam steering device and reflected from an object, and processor configured to control the beam steering device to acquire distance information by steering a traveling direction of light.

BRIEF DESCRIPTION OF THE DRAWINGS

The above and/or other aspects, features, and advantages of example embodiments of the disclosure will be more apparent from the following description taken in conjunction with the accompanying drawings, in which:

FIG. 1 is a diagram of a distance information acquisition apparatus according to an example embodiment;

FIG. 2 is a diagram of a distance information acquisition apparatus according to another example embodiment;

FIG. 3 is a conceptual diagram illustrating a beam steering device applied to the distance information acquisition apparatus of FIG. 1;

FIGS. 4A, 4B, 4C, and 4D exemplarily show displacements according to control signals of a periodic effective grating in the beam steering device of FIG. 3;

FIG. 5 shows a configuration of a beam steering device according to an example embodiment;

FIG. 6 shows a configuration of a beam steering device according to another example embodiment;

FIG. 7 shows examples of planar shapes of nano-antennas according to example embodiments;

FIGS. 8A, 8B, 8C, 8D, and 8E show various example embodiments of nano-antennas having a Fabry-Perot resonance structure;

FIG. 9 shows an implementation example of a beam steering device according to an example embodiment;

FIGS. 10, 11, and 12 show simulation results of the nano-antenna reflectance spectrum according to an applied voltage, a phase for each wavelength according to a discrete displacement of an effective grating, and the intensity of incident light of first-order diffracted light according to discrete displacement of effective grating of the beam steering device according to an example embodiment;

FIG. 13A is a graph showing a rate of change of a phase $\varphi$ with respect to a position x for a case when $\theta=6.95°$ using Equation 3;

FIG. 13B is a graph showing results of wrapping for an angle of 360° as in Equation 4 for the graph showing the rate of change of the phase $\varphi$ of FIG. FIG. 13A;

FIG. 14A shows an example of forming an effective grating of a beam steering device in which each pixel is periodically repeated;

FIG. 14B shows an example of forming an effective grating of a beam steering device with two pixel periods when two pixels have effective displacements of 0 degrees and 180 degrees;

FIG. 15A shows a result of a full field simulation when a light wave having an electric field in a direction perpendicular to the nano-antenna of the beam steering device of FIG. 14A is incident at an angle of 60 degrees;

FIG. 15B shows a result of a full field simulation when a light wave having an electric field in a direction perpendicular to the nano-antenna of the beam steering device of FIG. 14B is incident at an angle of 60 degrees;

FIG. 16 is a graph showing a beam steering angle for a case where the $\Lambda_{SC,2}$ part in Equation 7 is 330 nm $\times$ 4 $\times$ 2 $\times$ N (N is a natural number greater than or equal to 2);

FIGS. 17A and 17B show an example of a structure in which a plurality of pixels are two-dimensionally arranged;

FIG. 18A shows beam steering angles for wavelengths, in a case when the beam steering device has an AC-AC-DE-DE-AC-AC-DE-DE pixel MP1 and an AC-AC-DE-DE-AC-AC-DE-DE pixel MP2 that are repeated so that the effective displacements are all the same as 0°, as shown in FIG. 15A;

FIG. 18B shows beam steering angles for wavelengths, in a case when a voltage is applied to the pixel MP1 in the form of AC-AC-DE-DE-AC-AC-DE-DE, and to the pixel MP2 in the form of DE-DE-AC-AC-DE-DE, as shown in FIG. 15B;

FIG. 19 is a graph showing beam steering angles for wavelengths of 1350 nm, 1400 nm, 1450 nm, 1500 nm, 1550 nm, and 1600 nm for the case when a $\Lambda_{SC,2}$ part in Equation 7 is 330 nm $\times$ 4 $\times$ 2 $\times$ N, where N is a natural number of 2 or more;

FIG. 20 is a conceptual diagram illustrating a case in which the distance information acquisition apparatus according to an example embodiment is applied to a mobile device;

FIGS. 21 and 22 are conceptual views illustrating a case in which the distance information acquisition apparatus according to an example embodiment is applied to a vehicle; and

FIGS. 23 and 24 schematically show a beam steering apparatus to which the distance information acquisition apparatus according to an example embodiment is applied.

DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, example embodiments will be described in detail with reference to the accompanying drawings. In the drawings, like reference numerals refer to like elements, and the size of each component may be exaggerated for clarity and convenience of explanation. The example embodiments are capable of various modifications and may be embodied in many different forms.

Hereinafter, when a position of an element is described using an expression "above" or "on", the position of the element may include not only the element being "immediately on/under/left/right in a contact manner" but also being "on/under/left/right in a non-contact manner". Singular expressions include plural expressions unless the context clearly indicates otherwise. When a part "comprises" or "includes" an element in the specification, unless otherwise defined, it is not excluding other elements but may further include other elements.

The term "above" and similar directional terms may be applied to both singular and plural. With respect to operations that constitute a method, the operations may be performed in any appropriate sequence unless the sequence of operations is clearly described or unless the context clearly indicates otherwise. The operations may not necessarily be performed in the order of sequence.

Also, in the specification, the term "units" or "...modules" denote units or modules that process at least one function or operation, and may be realized by hardware, software, or a combination of hardware and software.

The connections of lines and connection members between constituent elements depicted in the drawings are examples of functional connection and/or physical or circuitry connections, and thus, in practical devices, may be expressed as replicable or additional functional connections, physical connections, or circuitry connections.

The use of all examples or example terms is merely for describing the technical scope of the inventive concept in detail, and thus, the scope of the inventive concept is not limited by the examples or the example terms as long as it is not defined by the claims.

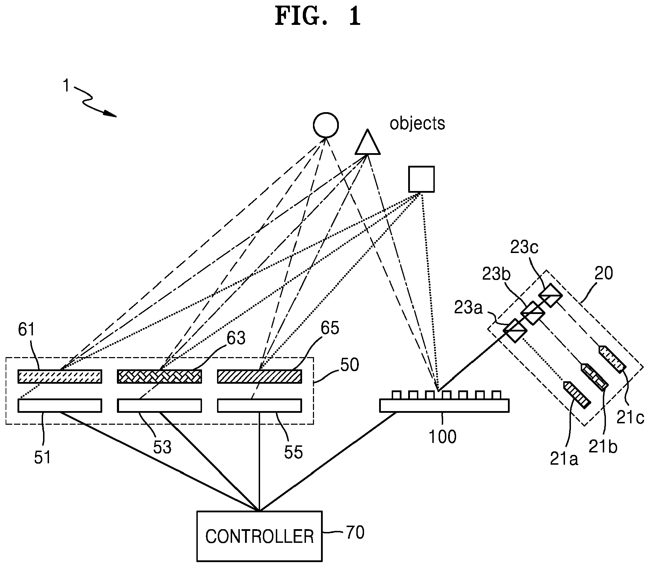

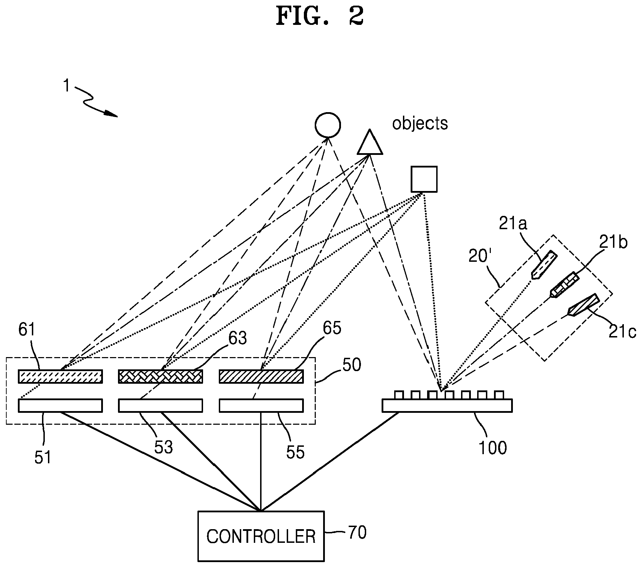

FIG. 1 is a diagram of a distance information acquisition apparatus 1 according to an example embodiment. FIG. 2 is a diagram of a distance information acquisition apparatus 1 according to another example embodiment.

Referring to FIGS. 1 and 2, the distance information acquisition apparatus 1 according to an example embodiment includes a plurality of light sources 21a, 21b, and 21c configured to emit light of different wavelengths, a beam steering device 100 configured to steer a traveling direction of incident light with an angle incident from the plurality of light sources 21a, 21b and 21c, a plurality of photodetectors 51, 53, and 55 configured to detect light steered by the beam steering device 100 and reflected from objects, and a controller 70 configured to control the beam steering device 100. The controller 70 may include an application specific integrated circuit (ASIC), a field-programmable gate array (FPGA), a dedicated microprocessor, a microprocessor, a general purpose processor, or the like.

According to the distance information acquisition apparatus 1 according to the example embodiment, at least two light sources from among the plurality of light sources 21a, 21b, and 21c emitting light of different wavelengths may be disposed so that emitted light is incident on the beam steering device 100 at the same angle of incidence, as shown in FIG. 1. In addition, according to the distance information acquisition apparatus 1 according to the example embodiment, at least two light sources from among the plurality of light sources 21a, 21b, and 21c emitting light of different wavelengths may be disposed so that emitted light is incident on the beam steering device 100 at different angles of incidence, as shown in FIG. 2.

The plurality of light sources, for example, a first light source 21a, a second light source 21b, and a third light source 21c, may emit first light, second light, and third light having different wavelengths. In FIGS. 1 and 2, it is depicted that the distance information acquisition apparatus 1 includes the first to third light sources 21a, 21b, and 21c as examples, but the number of light sources and the wavelength range of the emitted light may vary. Herewith, a case in which the distance information acquisition apparatus 1 includes the first to third light sources 21a, 21b, and 21c is described as an example.

At least two light sources from among the plurality of light sources 21a, 21b, and 21c may be disposed so that emitted light is incident on the beam steering device 100 at the same angle of incidence, as shown in FIG. 1. FIG. 1 exemplarily shows that all of the plurality of light sources, for example, the first to third light sources 21a, 21b and 21c are disposed such that, emitted light is incident on the beam steering device 100 at the same incident angle. However, this is only an example, and embodiments are not limited thereto.

The distance information acquisition apparatus 1 according to example an embodiment may further include an optical path combining unit configured to combine optical paths of light of different wavelengths emitted from the plurality of light sources, for example, first to third light sources 21a, 21b, and 21c, so that the light is incident on the beam steering device 100 in the same path. The plurality of light sources 21a, 21b, and 21c and the optical path combining unit may constitute a light transmission unit 20.

FIG. 1 shows an example of the optical path combining unit including a first beam splitter 23a, a second beam splitter 23b, and a third beam splitter 23c having transmissive/reflective surfaces parallel to each other, but the optical path combining unit may be provided in another form. For example, first light emitted from the first light source 21a may be reflected by the first beam splitter 23a and proceed to the beam steering device 100. Second light emitted from the second light source 21b may be reflected by the second beam splitter 23b, transmitted through the first beam splitter 23a, and proceed to the beam steering device 100. Third light emitted from the third light source 21c may be reflected by the third beam splitter 23c and proceed to the beam steering device 100 by passing through the second beam splitter 23b and the first beam splitter 23a. The first light to third light that may be emitted from the first to third light sources 21a, 21b, and 21c and combined by the optical path combining unit may proceed on the same optical path and be incident on the beam steering device 100 at an incident angle.

In this way, at least two light sources among the plurality of light sources, for example, the first to third light sources 21a, 21b, and 21c, may be arranged so that the emitted first light to third light are incident on the beam steering device 100 at the same angle of incidence, and an optical path combining unit may be further included to combine optical paths of the first light to third light.

According to another example embodiment, according to the distance information acquisition apparatus 1 according to an example embodiment, at least two light sources from among the plurality of light sources 21a, 21b, and 21c emitting light of different wavelengths may be arranged so that the emitted light is incident on the beam steering device 100 at different angles of incidence, as shown in FIG. 2. In the case of FIG. 2, a light transmission unit 20' may include a plurality of light sources 21a, 21b, and 21c without an optical path combining unit.

FIG. 2 shows a case in which all of the plurality of light sources, for example, the first to third light sources 21a, 21b, and 21c, are arranged so that the emitted first light to third light are incident on the beam steering device 100 at different angles of incidence, but embodiments are not limited thereto. In FIG. 2, it is depicted that the first light to third light emitted from the first to third light sources 21a, 21b, and 21c and traveling to the beam steering device 100 are incident on different positions on the beam steering device 100. However, this is only for indicating paths of the first light to third light, and the first light to third light are not limited to being incident on different positions on the beam steering device 100. The first light to third light emitted from the first to third light sources 21a, 21b, and 21c may be incident at the same position on the beam steering device 100 at different incident angles or may be incident at different positions on the beam steering device at different incident angles.

In this way, at least two light sources among the plurality of light sources, for example, the first to third light sources 21a, 21b, and 21c, may be arranged so that the emitted first light to third light are incident on the beam steering device 100 at different angles of incidence.

The first to third light sources 21a, 21b, and 21c may be provided to emit, for example, the first light to third light of different wavelengths in visible light range or a near-infrared range of about 800 nm to about 1700 nm. A semiconductor laser may be provided as the first to third light sources 21a, 21b, and 21c. A semiconductor laser applied as the first to third light sources 21a, 21b, and 21c may include, for example, any one of an edge emitting laser (EEL), a vertical cavity surface emitting laser (VCSEL), a photonic crystal surface emitting laser (PCSEL), and a laser diode (LD), or a combination thereof.

According to another example embodiment, the distance information acquisition apparatus 1 according to an example embodiment may further include a collimating lens configured to collimate the first light to third light or a focusing lens configured to focus the first light to third light on the beam steering device 100 on paths of the first light to third light emitted from the first to third light sources 21a, 21b, and 21c.

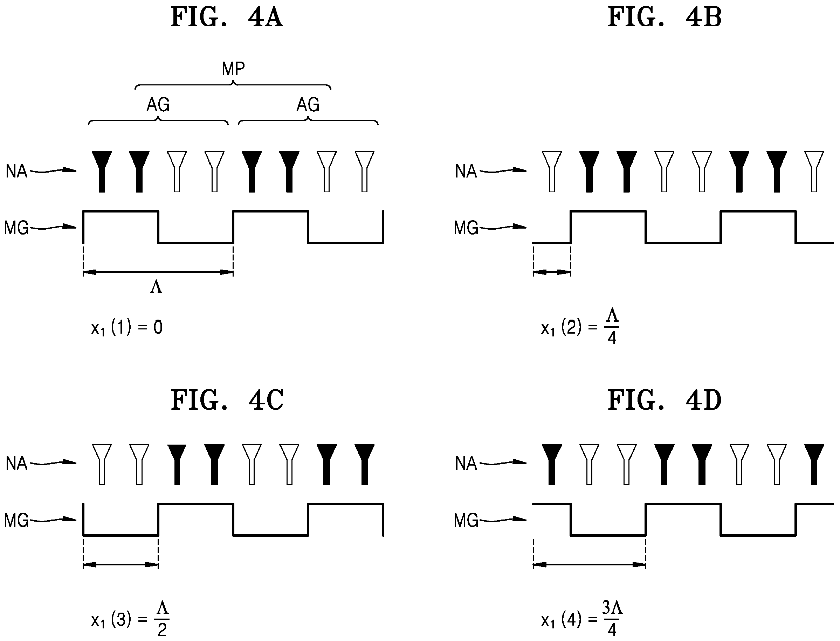

The beam steering device 100 may be provided to include a plurality of nano-antennas NA, form an effective grating (MG in FIG. 4), and modulate a phase by displacement of an effective grating MG to steer a traveling direction of light incident from the light sources 21a, 21b, and 21c at an angle of incidence. The beam steering device 100 may be provided to have beam steering angles that are different from each other according to a wavelength of the incident light.

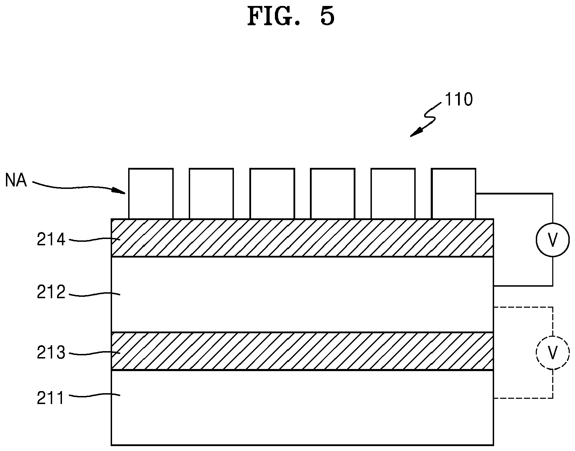

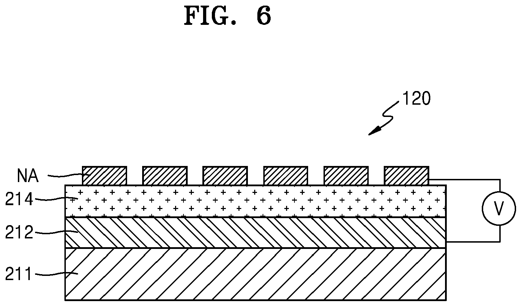

For example, as exemplarily shown in FIGS. 5 and 6 to be described later, the beam steering device 100 may include a reflective layer 211, an active layer 212 in which an optical property is changed according to a control signal, at least one insulating layer 213 or 214, and a plurality of nano-antennas NA, and may form a charge accumulation region or a charge depletion region in the active layer 212 to correspond to the nano-antenna NA according to a voltage applied to at least one of the nano-antennas NA and the reflective layer 211 to form an effective grating MG. The controller 70 may control a voltage applied to the beam steering device 100 to adjust the formation of the effective grating MG and the displacement of the effective grating MG. The phase of light incident on the beam steering device 100 is modulated by the displacement of the effective grating MG, and accordingly, a travelling direction of the light may be steered. Light steered by the beam steering device 100 may be, for example, first-order diffracted light.

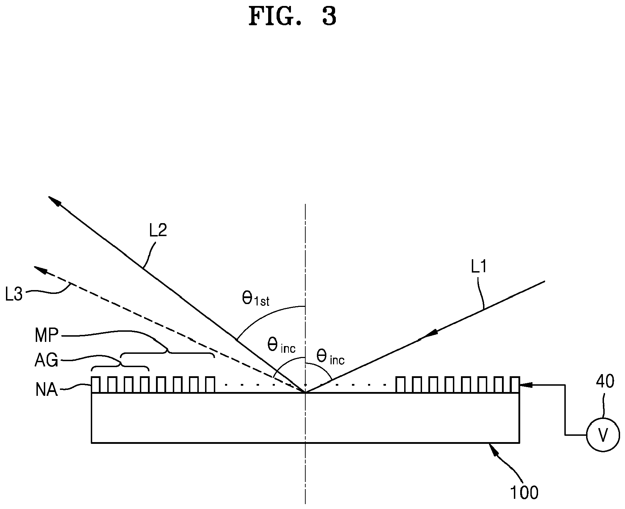

FIG. 3 is a conceptual diagram showing the beam steering device 100 applied to the distance information acquisition apparatus 1 of FIG. 1. FIG. 4 exemplarily shows displacement according to a control signal of the periodic effective grating MG in the beam steering device 100 of FIG. 3.

Referring to FIGS. 3 and 4, the beam steering device 100 may include a plurality of nano-antennas NA, may form a periodic effective grating MG corresponding to two or more nano-antennas NA, and modulate a phase by displacement of the effective grating MG according to a control signal of the controller 70. The beam steering device 100 may steer a traveling direction of light incident from the plurality of light sources 21a, 21b, and 21c at an incident angle. In FIG. 3, a driving unit 40 is configured to apply a driving voltage to the plurality of nano-antennas NA according to a control signal of the controller 70. In FIGS. 1 and 2, the driving unit 40 may be included in the controller 70. The driving unit 40 may be provided separately from the controller 70.

When the plurality of light sources, for example, the first to third light sources 21a, 21b, and 21c, emit first light to third light having different wavelengths in visible light range or in a near-infrared range of about 800 nm to about 1700 nm, the beam steering device 100 may operate in a visible light range and near-infrared range. However, embodiments are not limited thereto, and the beam steering device 100 may operate in various wavelength bands, for example, visible light and near infrared rays, as well as extreme ultraviolet rays, mid infrared rays, far infrared rays, tetrahertz (THz), gigahertz (GHz), and radio frequency (RF) regions.

The beam steering device 100 may be provided so that the effective grating MG is formed with a period corresponding to two or more, for example, four or more nano-antennas NA. When a brightness in which a bright nano-antenna NA and a dark nano-antenna NA is periodically repeated, it appears as if a grating exists, and this grating may be an effective grating MG (or meta-grating) and may correspond to a control signal pattern.

For example, as shown in FIG. 4A, when an effective grating MG of one period $\Lambda$ corresponds to four nano-antennas NA, and one period $\Lambda$ of the effective grating MG includes two bright antennas in the left half and two dark antennas in the right half, the displacement may be defined as 0, that is, $x_1(1)=0$. Based on when the displacement is 0, as shown in FIG. 4B, an effect of shifting the effective grating MG by $\Lambda/4$, that is, $x_1(2)=\Lambda/4$, may be given. In addition, as shown in FIG. 4C, an effect of shifting the effective grating MG by $\Lambda/2$, that is, $x_1(3)=\Lambda/2$, may be given, and as shown in FIG. 4D, an effect of shifting the effective grating MG by $3\Lambda/4$, that is, $x_1(4)=3\Lambda/4$, may be given. As described above, due to the movement x of the effective grating MG, the first-order diffracted light has a phase change $\varphi$ proportional to $x/\Lambda$.

For example, a displacement may be given to the effective grating MG according to a control signal applied to each of the plurality of nano-antennas NA, and the phase may be modulated by the displacement of the effective grating MG, and thus the traveling direction of incident light L1 incident on the beam steering device 100 with an incident angle $\theta_{inc}$ may be changed.

Light steered by the beam steering device 100 may be, for example, first-order diffracted light. For example, the incident light L1 incident with the incident angle $\theta_{inc}$ may be first-order diffracted by the beam steering device 100, and thus, output light L2 having an emission angle $\theta_{1st}$ may be obtained. The emission angle $\theta_{1st}$ of the output light L2 may vary according to a displacement of the effective grating MG. In addition, the emission angle $\theta_{1st}$ of the output light L2 may vary according to a wavelength of the incident light L1.

In FIG. 3, reflected light L3 is reflected at the same angle as the incident angle $\theta_{inc}$ when the incident light L1 having the incident angle $\theta_{inc}$ is reflected without diffraction to the first-order or more. As it may be seen from FIG. 3, a traveling direction of the steered output light L2 is different from the traveling direction of the reflected light L3, and the traveling direction of the output light L2 may vary according to the displacement of the effective grating MG.

Referring to FIGS. 1 and 2, the plurality of photodetectors 51, 53, and 55 may be provided to correspond to the plurality of light sources 21a, 21b and 21c to detect light steered by the beam steering device 100 and reflected from an object. For example, the plurality of photodetectors 51, 53, and 55 may include a first photodetector 51, a second photodetector 53, and a third photodetector 55 to correspond to the first to third light sources 21a, 21b, and 21c. The first photodetector 51 may detect the first light emitted from the first light source 21a, steered by the beam steering device 100, emitted to a scan point, and reflected from the object. The second photodetector 53 may detect the second light emitted from the second light source 21b, steered by the beam steering device 100, emitted to a scan point, and reflected from an object. The third photodetector 55 may detect the third light emitted from the third light source 21c, steered by the beam steering device 100, emitted to a scan point, and reflected from an object. The number of photodetectors may vary according to the number of light sources.

The plurality of photodetectors, for example, the first to third photodetectors 51, 53, and 55, may include, for example, a silicon photomultiplier (SiPM), an avalanche photodiode (APD), a single photon avalanche diode (SPAD), or a photo detector (PD), etc., and a distance between the distance information acquisition apparatus 1 and the object may be calculated by using a time difference between a light emission time and an arrival time of returning light by using a time-of-flight method.

Moreover, band pass filters 61, 63, and 65 may further be provided at front ends of the plurality of photodetectors 51, 53, and 55 to pass a wavelength band of emitted light of a corresponding light source from among the plurality of light sources 21a, 21b, and 21c and to block other wavelength bands of light or ambient light such as external illumination and sunlight. The plurality of photodetectors 51, 53, and 55 and the band pass filters 61, 63, and 65, etc. disposed respectively in front of the photodetectors 51, 53, and 55 may constitute a light receiving unit 50.

For example, a first band pass filter 61 configured to pass a wavelength band of the first light emitted from the first light source 21a corresponding thereto and blocking wavelength bands of the second light and third light or ambient light, such as external illumination and sunlight, may further be provided at the front end of the first photodetector 51. A second band pass filter 63 configured to pass a wavelength band of the second light emitted from the second light source 21b corresponding thereto and blocking wavelength bands of the first light and third light or ambient light, such as external illumination and sunlight, may further be provided at the front end of the second photodetector 53. A third band pass filter 65 configured to pass a wavelength band of the third light emitted from the third light source 21c corresponding thereto and blocking wavelength bands of the first light and second light or ambient light, such as external illumination and sunlight, may further be provided at the front end of the third photodetector 55. The number of band pass filters and the pass wavelength bands may vary depending on the number of light sources and the wavelength of the emitted light.

Furthermore, a condensing lens configured to condense the first light to third light reflected by the object to be detected by the first to third photodetectors 51, 53, and 55 may be further included.

As described above, in the distance information acquisition apparatus 1 according to an example embodiment, a plurality of light sources 21a, 21b, and 21c emitting light of different wavelengths and the beam steering device 100 that includes a plurality of nano-antennas NA and steers a traveling direction of incident light by modulating a phase by a displacement of an effective grating MG are applied, and thus, light may be emitted to a plurality of positions with respect to a control signal pattern input, and light in a plurality of positions reflected from at least one object may be detected by the plurality of photodetectors 51, 53, and 55. Thus, resolution of the distance information acquisition apparatus 1 may increase equal to the number of the plurality of light sources.

In addition, according to the distance information acquisition apparatus 1 according to an example embodiment, a beam may be steered by performing a phase modulation by displacement of the effective grating MG of the beam steering device 100, and also, light of different wavelengths from each other emitted from the plurality of light sources 21a, 21b, and 21c may be steered at different angles from each other. Thus, resolution may be increased to correspond to the use of light of the plurality of wavelengths.

Hereinafter, example embodiments of the beam steering device 100 being applied to the distance information acquisition apparatus 1 according to an example embodiment to steer light of different wavelengths emitted from the plurality of light sources 21a, 21b, and 21c at different angles from each other will be described.

FIG. 5 shows a configuration of a beam steering device 110 according to an example embodiment. FIG. 6 shows a configuration of a beam steering device 120 according to another example embodiment. The beam steering devices 110 and 120 of FIGS. 5 and 6 and the following example implementations may be applied to the beam steering device 100 of the distance information acquisition apparatus 1 according to an example embodiment.

Referring to FIGS. 5 and 6, the beam steering devices 110 and 120 include a reflective layer 211, an active layer 212 in which an optical property is converted according to a control signal, at least one of insulating layers 213 and 214, and a plurality of nano-antennas NA. In the beam steering devices 110 and 120, a charge accumulation region or a charge depletion region may be formed in the active layer 212 corresponding to the nano-antennas NA according to a voltage applied to at least one of the nano-antennas NA and the reflective layer 211, and thus, an effective lattice MG may be formed. The active layer 212 may be positioned between the reflective layer 211 and the plurality of nano-antennas NA. At least one of insulating layers 214 and 213 may be located at at least one of between the reflective layer 211 and the active layer 212 and between the active layer 212 and the plurality of nano-antennas NA. FIG. 5 shows an example in which the first insulating layer 214 is provided between the active layer 212 and the plurality of nano-antennas NA and the second insulating layer 213 is provided between the reflective layer 211 and the active layer 212. FIG. 6 shows an example in which only the first insulating layer 214 is provided between the active layer 212 and the plurality of nano-antennas NA.

As shown in FIG. 5, the reflective layer 211, for example, may reflect light and simultaneously perform the function of an electrode. As another example, the reflective layer 211 may only reflect light, as shown in FIG. 6. The reflective layer 211 may be optically coupled to the nano-antennas NA, and light may be reflected by an optical interaction between the nano-antennas NA and the reflective layer 211. The reflective layer 211 may include a predetermined conductor, such as a metal. For example, the reflective layer 211 may include at least one metal selected from the group consisting of copper (Cu), aluminum (Al), nickel (Ni), iron (Fe), cobalt (Co), zinc (Zn), titanium (Ti), ruthenium (Ru), rhodium (Rh), palladium (Pd), platinum (Pt), osmium (Os), iridium (Ir), silver (Ag), gold (Au), etc. or an alloy including at least one of these materials. According to another example embodiment, the reflective layer 211 may include a thin film in which metal nano-particles, such as Ag or Au, are dispersed, a carbon nano-structure, such as graphene or CNT, a conductive polymer, such as poly(3,4-ethylenedioxythiophene) (PEDOT), polypyrrole (PPy), poly(3-hexylthiophene) (P3HT), or may include a conductive oxide, etc.

The nano-antennas NA capture energy by converting incident light (including both visible and invisible electromagnetic waves) of a specific wavelength (or frequency) into a form of localized surface plasmon resonance, and may be referred to as a nano-structured antenna with respect to light. The nano-antenna NA may be a conductive pattern (e.g., a metal pattern). For example, the nano-antenna NA may be a metal nano-antenna NA. The conductive pattern may be in contact with a non-conductive layer (e.g., a dielectric layer). Plasmon resonance may occur at an interface between the conductive pattern and the non-conductive layer (e.g., a dielectric layer). In this case, the non-conductive layer (e.g., a dielectric layer) may be the first insulating layer 214, or a layer other than the first insulating layer 214. For convenience, hereinafter, it will be described that the conductive pattern itself is a nano-antenna NA. An interface where surface plasmon resonance occurs, such as the interface between a conductive pattern and a non-conductive layer (e.g., a dielectric layer) may be collectively referred to as a "meta surface" or a "meta structure".

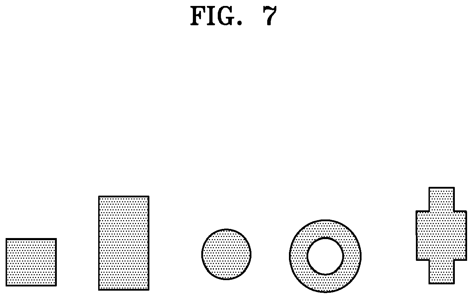

FIG. 7 shows examples of planar shapes of the nano-antennas NA according to example embodiments. As shown in FIG. 7, the nano-antennas NA may have various planar shapes, such as a square, a rectangle, a circle, a donut, and a cross. The nano-antennas NA may have a dimension of sub-wavelengths. Here, a sub-wavelength may be a dimension less than an operating wavelength of the nano-antennas NA. Any dimension constituting the shape of the nano-antennas NA, for example, at least one of thickness, width, length, and spacing between the nano-antennas NA may have a dimension of sub-wavelengths. The resonance wavelength may vary depending on the shape or size of the nano-antennas NA.

The nano-antennas NA may include a metal material having high conductivity capable of generating surface plasmon excitation. For example, the nano-antennas NA may include at least one metal selected from the group consisting of Cu, Al, Ni, Fe, Co, Zn, Ti, Ru, Rh, Pd, Pt, Os, Ir, Ag, Au, etc., or an alloy including at least one of these materials. According to another example embodiment, the nano-antennas NA may include a thin film in which metal nano-particles, such as Ag or Au, are dispersed, a carbon nano-structure, such as graphene or CNT, a conductive polymer, such as PEDOT, PPy, or P3HT, or may include a conductive oxide, etc. The nano-antennas NA and the reflective layer 211 may include the same metal or different metals from each other. The nano-antennas NA may be a dielectric antenna.

The active layer 212 may be a layer whose optical property changes according to its electrical conditions. The permittivity or refractive index of the active layer 212 may be changed according to electrical conditions related to the active layer 212 and its surrounding region. The change in the permittivity of the active layer 212 may be caused by a change in the charge concentration (charge density) of a region or regions in the active layer 212. For example, the permittivity of the active layer 212 may be changed by a change in the charge concentration of the region(s) in the active layer 212. The permittivity of the active layer 212 may be changed according to an electric field or voltage applied to the active layer 212. The active layer 212 may include, for example, a semiconductor, an oxide, a nitride, or a liquid crystal. The active layer 212 may include transparent conductive oxide (TCO), such as indium tin oxide (ITO), indium zinc oxide (IZO), aluminum zinc oxide (AZO), gallium zinc oxide (GZO), aluminum gallium zinc oxide (AGZO), or gallium indium zinc oxide (GIZO). The active layer 212 may include a transition metal nitride (TMN), such as titanium nitride (TiN), zirconium nitride (ZrN), hafnium nitride (HfN), or tantalum nitride (TaN), a phase change material, graphene, a transition metal dichalcogenide, or a two-dimensional material, etc. In addition, the active layer 212 may include an electro-optical (EO) material whose effective permittivity changes when an electrical signal is applied. The EO material may include, for example, a crystalline material, such as lithium niobate ($LiNbO_3$), lithium tantalite ($LiTaO_3$), potassium tantalate niobate (KTN), lead zirconate titanate (PZT), or various polymers having EO properties.

The first insulating layer 214 or the second insulating layer 213 may include an insulating material (dielectric material). The first insulating layer 214 or the second insulating layer 213 may include at least one of an insulating silicon compound and an insulating metal compound. The insulating silicon compound may include, for example, silicon oxide (SiOx), silicon nitride (SixNy), silicon oxynitride (SiON), and the like, and the insulating metal compound may include, for example, aluminum oxide ($Al_2O_3$), hafnium oxide (HfO), zirconium oxide (ZrO), hafnium silicon oxide (HfSiO), and the like. The first insulating layer 214 and the second insulating layer 213 may include the same material or may have different material compositions.

Referring to FIG. 5, the active layer 212 may be electrically insulated from the nano-antennas NA by the first insulating layer 214, and the active layer 212 may be electrically insulated from the reflective layer 211 by the second insulating layer 213. According to a voltage (control signal) applied between the active layer 212 and the nano-antennas NA, the charge concentration of a first boundary region of the active layer 212 with the first insulating layer 214 may be changed. In addition, according to a voltage (driving signal) applied between the reflective layer 211 and the active layer 212, the charge concentration of a second boundary region of the active layer 212 with the second insulating layer 213 may be changed. Each of the first boundary region and the second boundary region may be divided into a plurality of unit regions respectively corresponding to the plurality of nano-antennas NA, and each of the plurality of unit regions may be a charge accumulation region or a charge depletion region according to a voltage. When the voltage applied to the nano-antennas NA is greater than the voltage applied to the active layer 212, a charge accumulation region may be formed on an upper part of the active layer 212. When the voltage applied to the nano-antennas NA is less than the voltage applied to the active layer 212, a charge depletion region may be formed on an upper part of the active layer 212. When the voltage applied to the reflective layer 211 is greater than the voltage applied to the active layer 212, a charge accumulation region may be formed on a lower part of the active layer 212. When the voltage applied to the reflective layer 211 is less than the voltage applied to the active layer 212, a charge depletion region may be formed on a lower part of the active layer 212. As the charge accumulation region and/or the charge depletion region are formed in the active layer 212, the reflection characteristics of the beam steering device 110 may be controlled. Accordingly, an effective grating MG, that is, a meta grating MG, may be formed, and by appropriately arranging the geometric phases of a plurality of pixels MP, the direction of first-order diffracted light may be controlled, and thus, the traveling direction of light may be steered.

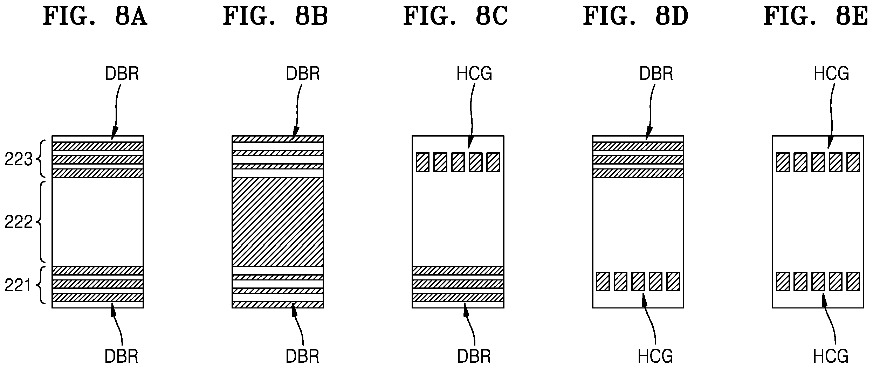

Referring to FIG. 6, the active layer 212 may be electrically insulated from the nano-antenna- NA by the first insulating layer 214. According to a voltage (control signal) applied between the active layer 212 and the nano-antenna NA, the charge concentration of a first boundary region of the active layer 212 with the first insulating layer 214 may be changed. The first boundary region may be divided into a plurality of unit regions corresponding to the plurality of nano-antennas NA, and each of the plurality of unit regions may be a charge accumulation region or a charge depletion region according to a voltage. When the voltage applied to the nano-antennas NA is greater than a voltage applied to the active layer 212, a charge accumulation region may be formed on an upper part of the active layer 212. When the voltage applied to the nano-antenna NA is less than the voltage applied to the active layer 212, a charge depletion region may be formed on an upper part of the active layer 212. As the charge accumulation region and/or the charge depletion region are formed in the active layer 212, the reflection characteristics of the beam steering device 120 may be controlled. Accordingly, an effective grating MG, that is, a meta grating MG, may be formed, and by appropriately arranging the geometric phases of a plurality of pixels MP, the direction of the first-order diffracted light may be controlled, and thus, the traveling direction of light may be steered. In the beam steering devices 110 and 120 according to the example embodiments, the plurality of nano-antennas NA may include, for example, a metal material or may have a Fabry-Perot resonance structure. FIG. 8 shows various example embodiments of nano-antennas NA having a Fabry-Perot resonance structure.

Referring to FIG. 8, the nano-antennas NA may include a first reflector 221, a cavity layer 222 on the first reflector 221, and a second reflector 223 on the cavity layer 222.

As exemplarily shown in FIGS. 8A and 8B, both the first reflective structure 221 and the second reflective structure 223 may be distributed Bragg reflectors (DBR) in which material layers having different refractive indices are alternately stacked. As exemplarily shown in FIG. 8C, the first reflective structure 221 may be a DBR, and the second reflective structure 223 may be a grating reflective structure such as a high contrast grating (HCG) in which a column, disk, or grating structure having a high refractive index is surrounded by a medium having a low refractive index. As exemplarily shown in FIG. 8D, the first reflective structure 221 may be a grating reflective structure (HCG), and the second reflective structure 223 may be a DBR. As exemplarily shown in FIG. 8E, both the first reflective structure 221 and the second reflective structure 223 may be grating reflective structures (HCGs).

One of the first reflective structure 221, the cavity layer 222, and the second reflective structure 223 may be an active layer in which optical properties, for example, refractive index and permittivity, are changed by a driving signal. The driving signal may be, for example, a voltage signal, or a heating signal for applying heat to a corresponding component. For example, the cavity layer 222 may be an active layer. In this case, the cavity layer 222 may include the same material as the active layer 212 of FIGS. 5 and 6. At least one of the layers constituting the first reflective structure 221 or the second reflective structure 223 may be an active layer whose optical property is changed in response to a driving signal. For example, at least one layer of the first reflective structure 221 may be an electro-optic material layer including an EO material whose effective permittivity changes when an electrical signal is applied. For example, at least one layer of the second reflective structure 223 may be an electro-optic material layer including an EO material whose effective permittivity changes when an electrical signal is applied. The electro-optic material layer of the first reflective structure 221 and/or the second reflective structure 223 may include, for example, silicon (Si). Accordingly, when electric power is applied from an external power source, the refractive index of the electro-optic material layer of the first reflective structure 221 and/or the second reflective structure 223 is changed, and a phase of light resonant between the first reflective structure 221 and the second reflective structure 223 is changed.

A resonance wavelength, a width of the resonance wavelength, a resonance polarization characteristic, a resonance angle, reflection/transmission/scattering characteristics, etc. may vary depending on the structure/shape of the nano-antenna NA and an arrangement thereof. Accordingly, the beam steering devices 100, 110, and 120 having characteristics suitable for the purpose may be manufactured by controlling the structure/shape and arrangement method of the nano-antennas NA.

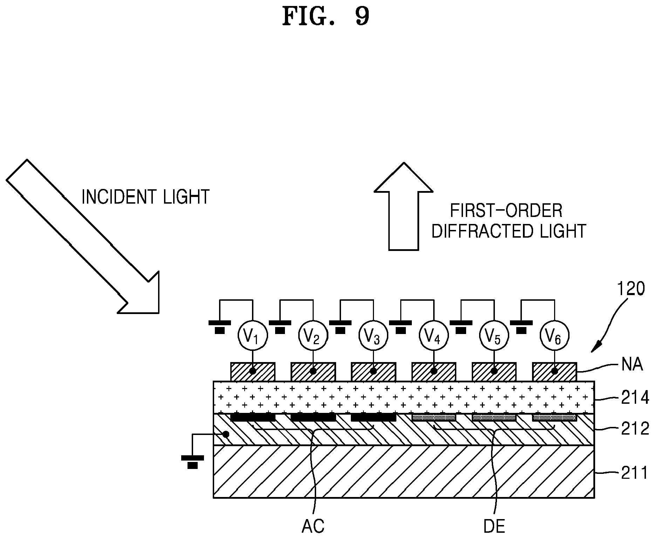

FIG. 9 shows an implementation example of the beam steering device 120 according to an example embodiment. FIG. 9 exemplarily shows a case in which one antenna group AG has six nano-antennas NA, this is only an example, and embodiments are not limited thereto. For example, one pixel MP may include one or more antenna groups AG, and each antenna group AG may include two or more nano-antennas NA.

Referring to FIG. 9, the beam steering device 120 may include, for example, the structure shown in FIG. 6, the reflective layer 211 may include Au, the active layer 212 may include ITO, the first insulating layer 214 may include oxide, and the nano-antennas NA may include Au. A thickness of the active layer 212 may be about 10 nm, and a thickness of the reflective layer 211 may be semi-infinite. A control signal may be applied between the active layer 212 and the nano-antennas NA. The active layer 212 may be a common electrode, and individual control signals may be applied to the nano-antennas NA. The nano-antennas NA each may act as an antenna and an electrode.

As exemplarily shown in FIG. 9, when a positive voltage is applied to the nano-antennas NA and the active layer 212 is grounded, in a first boundary region between the active layer 212 and the first insulating layer 214, the concentration of free electrons may be increased, resulting in a charge accumulation (AC) state, and when a negative voltage is applied to the nano-antennas NA, in the first boundary region between the active layer 212 and the first insulating layer 214, the concentration of free electrons may be reduced, resulting in a charge depletion (DE) state. FIG.

9 shows an example of forming three gratings in a charge accumulation state (AC) state by applying positive voltages ($V_1$, $V_2$, and $V_3$) to three adjacent nano-antennas NA, and three gratings in a charge depletion state (DE) by applying negative voltages ($V_4$, Vs, and $V_6$) to three adjacent nano-antennas NA. For example, FIG. 9 shows an example in which one antenna group AG has six nano-antennas NA and a phase displacement is 0 degree.

As exemplarily shown in FIG. 9, one pixel MP may include, for example, one antenna group AG, and the one antenna group AG may include six nano-antennas NA. In this case, for example, when the period of the nano-antenna NA is about 400 nm, the width of the nano-antenna NA is about 200 nm, and the thickness of the nano-antenna NA is about 20 nm, the period of the antenna group AG may be 400 nm $\times$ 6 = 2400 nm, and the period of the pixel MP may be 2400 nm. Here, one pixel MP may include two or more antenna groups AG, and each antenna group AG may include two or more nano-antennas NA, for example, two, three, four, six or more nano-antennas NA.

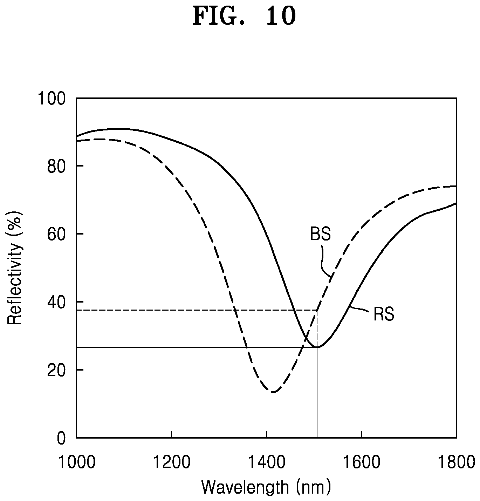

FIGS. 10 to 12 show simulation results of a reflectance spectrum of the nano-antennas NA according to an applied voltage, a phase of each wavelength according to discrete displacement of the effective grating MG, and the intensity of first-order diffracted light with respect to incident light according to the discrete displacement of the effective grating MG of the beam steering device 120 according to an example embodiment.

FIGS. 10 to 12 show characteristics of the beam steering device 120 according to the example embodiment in the structure shown in FIG. 9 when the nano-antennas NA include Au antennas having a period of about 400 nm, a width of about 200 nm, and a thickness of about 50 nm, wherein the first insulating layer 214 includes an hafnium oxide ($HfO_2$) insulating material with a thickness of about 20 nm; and the active layer 212 below the nano-antennas NA includes ITO with a thickness of about 10 nm.

When the active layer 212 is grounded, if a voltage applied to an upper part the beam steering device 120 through the nano-antennas NA is a positive voltage, the concentration of free electrons in the first boundary region between the active layer 212 and the first insulating layer 214 increases, and thus, the first boundary region is in a charge accumulation state (AC in FIG. 9), and accordingly, the refractive index of the active layer 212 is reduced and the resonance wavelength is shortened. As a result, the reflectance may be blue-shifted as indicated by BS in FIG. 10. On the other hand, if the voltage applied to the upper part of the beam steering device 120 through the nano-antennas NA is a negative voltage, the concentration of free electrons in the first boundary region between the active layer 212 and the first insulating layer 214 is reduced, and thus, the first boundary region is in a charge depletion state (DE in FIG. 9), and accordingly, the refractive index of the active layer 212 increases and the resonance wavelength becomes longer. As a result, the reflectance may be red-shifted as indicated by RS in FIG. 10. Reviewing the reflectance spectrum of FIG. 10, when light of a wavelength of about 1500 nm is incident on the beam steering device 120 at an incident angle of about 40 degrees, the reflectance of the nano-antennas NA is about 38% in the case of charge accumulation (AC) state, and is about 22% in the case of charge depletion state. For example, a contrast of approximately 16%, which is the difference between the two reflectance may be obtained.

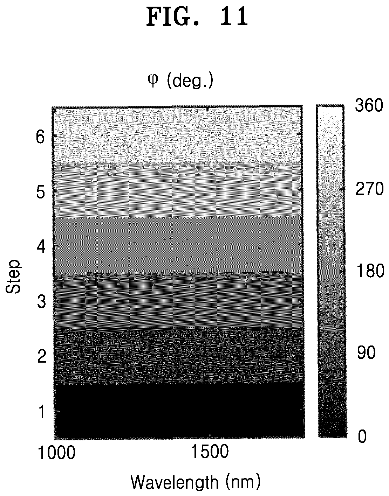

FIG. 11 shows a geometric phase of first-order diffracted light in the structure of the beam steering device 120 of FIG. 9 in the case when 3 gratings to which charge accumulation (AC) is applied and 3 gratings to which charge depletion is applied are used and when the displacement of the effective grating MG is increased by increasing a step sideways one-by-one. The geometric phase may have a value of about 0 degree, about 60 degrees, about 120 degrees, about 180 degrees, about 240 degrees, or about 300 degrees depending on the displacement of the effective grating MG. These values of the geometric phase may appear in common in a wavelength range of the incident light of about 1000 nm to about 1800 nm. From this, it may be seen that phase modulation may occur relatively smoothly in a wide wavelength band in the beam steering device 120 according to the example embodiment.

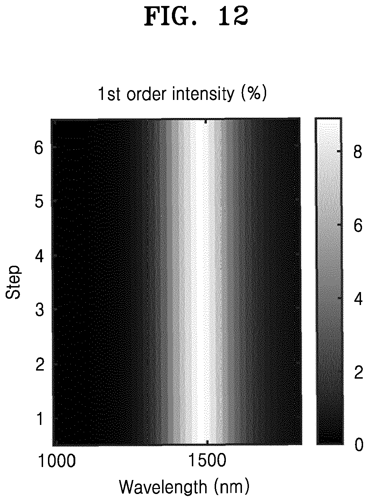

FIG. 12 shows a ratio (%) of the intensity of the first-order diffracted light with respect to the incident light for each wavelength. The highest intensity of about 5% is shown at a wavelength near about 1500 nm by an antenna length of about 200 nm, and there is an advantage in that the intensity ratio of the first-order diffracted light does not change when the displacement is changed for a fixed wavelength. The intensity ratio of the first-order diffracted light may vary depending on a wavelength, and it may be seen that a high intensity ratio of about 2% or more may be maintained in a wavelength band range from about 1350 nm to about 1580 nm (the band range of about 230 nm).

Referring to FIGS. 3 and 4, the beam steering device 100 according to an example embodiment may include a plurality of pixels MP. Each of the plurality of pixels MP may include a plurality of nano-antennas NA. As a periodic and discrete control signal is applied to the plurality of nano-antennas NA of each of the plurality of pixels MP, the optical intensity of the plurality of nano-antennas NA is changed, and thus, a traveling direction of incident light L1 to be emitted may be changed. The pattern of a control signal may correspond to the effective grating MG, and may be periodic for each pixel MP. Each of the plurality of pixels MP may include one or more antenna groups AG as exemplarily shown in FIGS. 3 and 4. Each antenna group AG may include a plurality of nano-antennas NA. In this case, a control signal may be periodic for each antenna group AG. For example, as shown in FIG. 4, the period of the control signal pattern may be the same as a period $\Lambda$ of the antenna group AG. When each pixel MP includes two or more antenna groups AG, as exemplarily shown in FIG. 4, a control signal of the same pattern may be applied to the two or more antenna groups AG, and when each antenna group AG includes N nano-antennas NA, a phase displacement may be provided in a step of Λ/N or a step multiple thereof. In FIGS. 3 and 4, as an example, it is shown that one antenna group AG includes four nano-antennas NA, and a control signal is applied to give a phase displacement in a step of Λ/4.

The number of antenna groups AG of each pixel MP and the number of nano-antennas NA included in each antenna group AG may be appropriately determined according to the range and step of the geometric phase to be expressed. As the number of antenna groups AG of each pixel MP increases, the precision of beam steering may be improved. Accordingly, although it is ideal that the number of antenna groups AG of each pixel MP is infinite, the number of antenna groups AG may be appropriately determined according to the required beam steering precision. For example, each pixel MP may include two to three antenna groups AG.

The plurality of pixels MP may have a one-dimensional array structure. One-dimensional beam steering is possible by appropriately arranging the geometric phases of the plurality of pixels MP. In addition, the plurality of pixels MP may have a two-dimensional array structure. Two-dimensional beam steering is possible by appropriately arranging the geometric phases of the plurality of two-dimensionally arranged pixels MP. The light may be a plane wave, a spherical wave, a Gaussian beam, or the like.

The reflected light may include a main lobe and a side lobe. When 0th-order diffracted light is steered, undesired side lobe may be generated and a signal-to-noise ratio (SNR) may be lowered.

In the example embodiment, the first-order diffracted light is emitted as a steering beam, and the reflected light L3 indicated by a dotted line in FIG. 3 corresponds to the 0th-order diffracted light of the incident light L1 when the displacement of the geometric phase of the plurality of pixels MP is zero. Similar to the beam steering device 100 according to an example embodiment, when the first-order diffracted light is steered, because a ratio of side lobe light is lower than that of the 0th-order light, a relatively good signal-to-noise ratio may be obtained.

The distance information acquisition apparatus 1 according to the example embodiment may be provided to emit the first-order diffracted light of the incident light L1 by the effective grating MG of the beam steering device 100, that is, the meta grating, as output light L2, and, for this purpose, may further include an output optical system for emitting the first-order diffracted light as the output light L2. The output optical system may include one or more optical devices, for example, a lens, etc. to shape the first-order diffracted light into a desired shape and to output the first-order diffracted light.

The beam steering angle by the beam steering device 100 according to an example embodiment may be determined as follows by phase modulation of the effective grating MG. The beam steering angle may be determined according to a phase value expressed in each pixel.

The first-order diffracted light has a phase change $\varphi_l$ as in Equation 1 by an effective movement $x_l$ of a grating having a period of Λ.

[Equation 1]

$$\varphi_l = 2\pi \times \frac{x_l}{\Lambda}$$

As in Equation 1, the phase change is proportional to an effective displacement.

When assuming that a beam steering angle is θ, a phase in Equation 1 by an effective displacement at a position x is φ, a wavelength of light incident on the beam steering device 100 is $\lambda_0$, and a wavenumber is ko, Equation 2 is obtained

[Equation 2]

$$\varphi(x) = k_0 \, x \sin\theta = \frac{360°}{\lambda_0} x \sin\theta$$

The rate of change (slope) of the phase φ with respect to the position x may be expressed by Equation 3.

[Equation 3]

$$\varphi(x) = k_0 \, x \sin\theta = \frac{360°}{\lambda_0} x \sin\theta$$

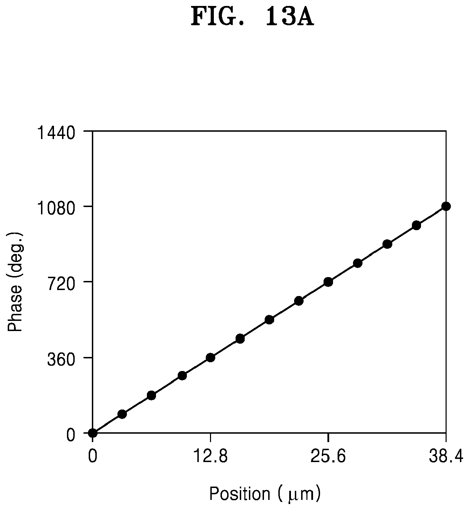

When Equation 3 is used, for a case of θ=6.95°, the rate of change of the phase φ with respect to the position x may be given as 28.125°/μm. This relationship may be represented as a graph of FIG. 13A. In FIG. 13A, a solid line indicates a phase value required when there is a continuous light source, and black points indicate values sampled from discretely distributed light sources.

In the pixel constituting an actual phase modulation array, since the range of angles that may be expressed is limited from 0° to 360°, the phase may be wrapped for an angle of 360° as in Equation 4.

[Equation 4]

$$\varphi_{wrap}(x) = \varphi(x) \ mod \ 360°$$

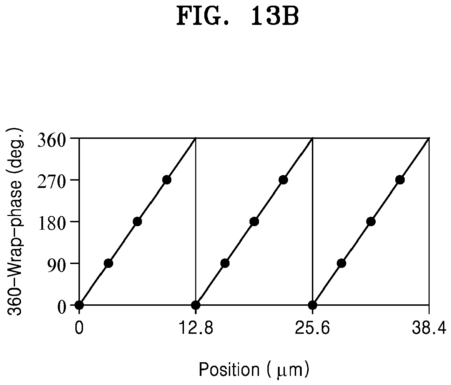

Here, mod means modulo operation. When a modulo operation is performed in this way, a 360°-wrapped phase has a periodic distribution as shown in FIG. 13B. When the wrapped phase is periodically repeated, it is referred to a super cell, and a phase modulation angle (beam steering angle) may be inversely proportional to the super cell period $\Lambda_{SC}$ as in Equation 5.

[Equation 5]

$$\Lambda_{sc} = \frac{\lambda_0}{sin\theta}$$

For example, when a wavelength equation is about 1.55 $\mu$m and a phase modulation angle (beam steering angle) is $\theta$ = 6.95°, the super cell period $\Lambda_{SC}$ may be given as about 12.8 $\mu$m.

When an incident angle of light emitted from a light source and incident to the beam steering device 100 and an emission angle of the first diffracted light emitted from the beam steering device 100 are $\theta_{inc}$ and $\theta_{1st}$, respectively, the wavelength of incident light is $\lambda_0$, and when the super cell corresponds to one antenna group AG, the effective grating MG is formed in an arrangement of the first order period corresponding to the period $\Lambda_{SC,1}$ of the antenna group AG, and the effective displacement of pixels MP is 0 degrees, the emission angle $\theta_{1st}$ of the first-order diffracted light may be given as in Equation (6).

[Equation 6]

$$\theta_{1st} = \sin^{-1}(\sin\theta_{inc} - \frac{\lambda_0}{\Lambda_{SC,1}})$$

In addition, because the period of one antenna group AG is $\Lambda_{SC,1}$ and a plurality of pixels having different effective displacements of the effective grating MG form a superpixel, the period of a secondary superpixel may correspond to a sum of periods of the plurality of pixels having different effective displacements. For example, when the effective displacement between adjacent pixels are 0 degrees and 180 degrees, two pixels having the effective displacements of 0 degrees and 180 degrees form a super-pixel, and thus, the period of the secondary super pixel may correspond to twice the period of each pixel, that is, the sum of the periods of the two pixels. For example, when one pixel includes two antenna groups AG and the period of the secondary superpixel corresponds to the sum of the periods of the two pixels, a period of the secondary superpixel, that is, a secondary period $\Lambda_{SC,2}$ of the effective grating MG may be four times the period $\Lambda_{SC,1}$ of one antenna group AG. In this way, when the effective grating MG has a first period $\Lambda_{SC,1}$ corresponding to the period of one antenna group AG and a second period $\Lambda_{SC,2}$ corresponding to the period of the secondary superpixel, the emission angle $\theta_{1st}$ of the first-order diffracted light may be given as in Equation 7.

[Equation 7]

$$\theta_{1st} = \sin^{-1}(\sin\theta_{inc} - \frac{\lambda_0}{\Lambda_{SC,1}} + \frac{\lambda_0}{\Lambda_{SC,2}})$$

As may be seen from Equations 6 and 7, the emission angle $\theta_{1st}$ of the first-order diffracted light, that is, a beam steering angle may vary depending on the period of the effective grating MG and the wavelength $\lambda_0$ of incident light.

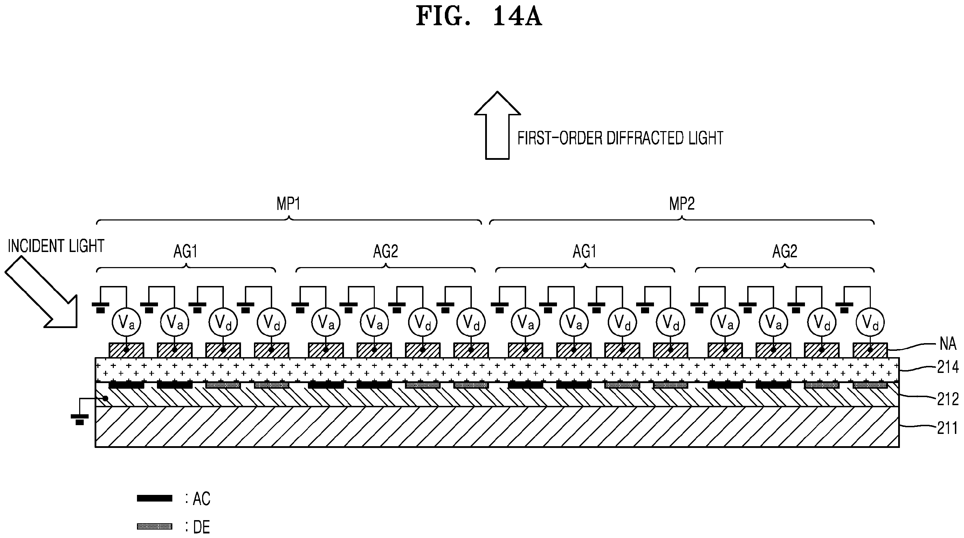

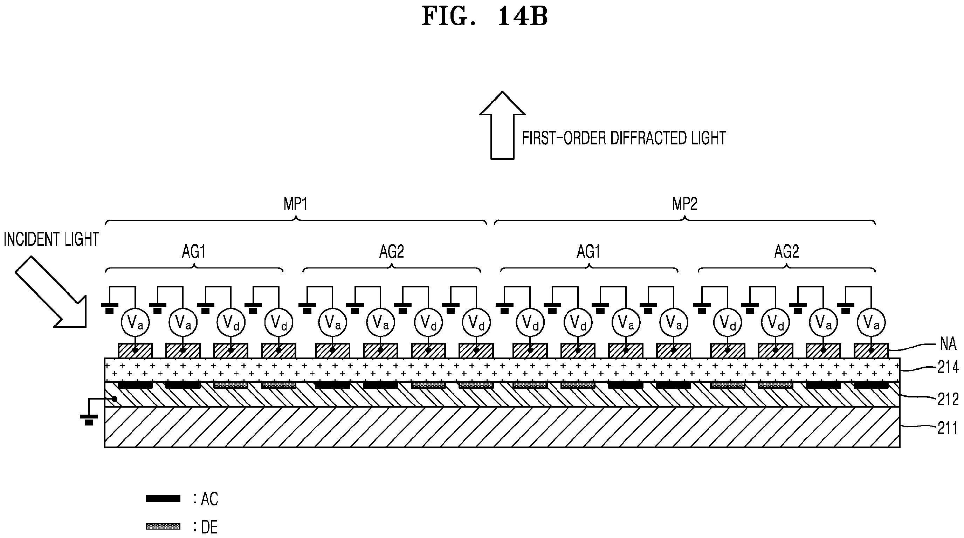

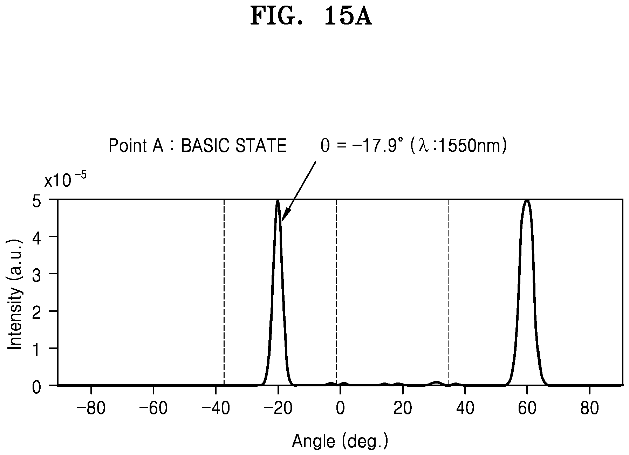

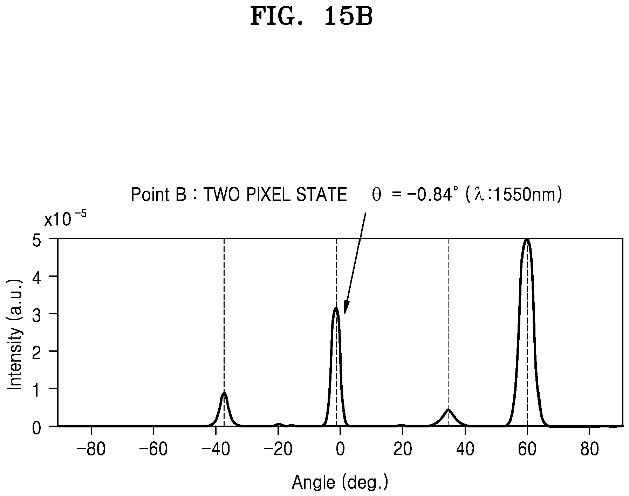

As in FIGS. 14A and 14B, when the effective grating MG of the beam steering device 100 is formed, a steering angle of the first-order diffracted light may be obtained from Equations 6 and 7 as shown in FIGS. 15A and 15B.

FIG. 14A shows an example of forming an effective grating MG of the beam steering device 100 in which each pixel MP is periodically repeated, and FIG. 14B shows an example of forming an effective grating MG of the beam steering device 100 in two pixel periods, where the two pixels have effective displacements of 0 degrees and 180 degrees.

FIGS. 14A and 14B show an example in which the beam steering device 100 has the structure shown in FIG. 6, and a total of eight nano-antennas NA are disposed in one pixel. As exemplarily shown in FIGS. 14A and 14B, each of the pixels MP1 and MP2 may be formed in a form in which four nano-antennas NA are grouped to form two antenna groups AG1 and AG2, that is, two gratings include by grouping. In FIGS. 14A and 14B, the two pixels MP1 and MP2 may be one-dimensionally arranged. Each of the two pixels MP1 and MP2 may have, for example, two antenna groups AG1 and AG2, and each of antenna group AG1 and AG2 has four nano-antennas NA. In FIGS. 14A and 14B, AC indicates a charge accumulation region, and DE indicates a charge depletion region.

FIG. 14a shows a case in which an AC-AC-DE-DE-AC-AC-DE-DE pixel (MP1) and an AC-AC-DE-DE-AC-AC-DE-DE pixel (MP2) are repeated, and thus, an effective displacement is all the same as zero degree. FIG. 14B shows a case in which a voltage is applied to the pixel MP1 in the form of AC-AC-DE-DE-AC-AC-DE-DE, and a voltage is applied to the pixel MP2 in the form of DE-DE-AC-AC-DE-DE-AC-AC, and thus, the effective displacements of the pixel MP1 and the pixel MP2 are different as 0 degrees and 180 degrees, and a total of 16 nano-antennas NA form one period and are repeated. In FIGS. 14A and 14B, Va indicates a voltage that forms a charge accumulation region, and Vd indicates a voltage that forms a charge depletion region.

FIG. 15A shows a full field simulation result when a light wave having an electric field in a direction perpendicular to the nano-antennas NA of the beam steering device 100 of FIG. 14A is incident at an angle of 60 degrees. The simulation conditions are as follows. The reflective layer 211 may include Au, the active layer 212 may include ITO, the first insulating layer 214 may include oxide, and the nano-antenna NA may include Au. The nano-antennas NA may have a period of about 330 nm, a width of about 210 nm, and a thickness of about 50 nm, the active layer 212 may have the thickness of about 5 nm, and the doping concentration of about $5 \times 10^{20}/\text{cm}^3$. The first insulating layer 214 may have a thickness of about 10 nm and a refractive index of about 2.0. The thickness of the reflective layer 211 may be semi-infinite.

As in FIG. 14A, when the effective displacement is 0 by repeating the AC-AC-DE-DE-AC-AC-DE-DE pixel (MP1) and the AC-AC-DE-DE-AC-AC-DE-DE pixel (MP2), the effective lattice MG is repeated with one period of AC-AC-DE-DE, $\Lambda_{SC,1}$=330 nm $\times$ 4 = 1320 nm. In the case of such a basic state, when an emission angle (beam steering angle) of the first-order diffracted light is obtained by applying A = 1550 nm to Equation 6, as indicated by Point A in FIG. 15A, about -17.9 degrees of emission angle may be obtained.

FIG. 15B shows a full field simulation result when a light wave having an electric field in a direction perpendicular to the nano-antenna NA of the beam steering device 100 of FIG. 14B is incident at an angle of 60 degrees. The simulation conditions are the same as the conditions applied to obtain the result of FIG. 15A, and only a shape of the voltage applied to the pixel MP1 and the pixel MP2 is different.

As in FIG. 14B, when two pixels form one period by applying a voltage to the pixel MP1 in the form of AC-AC-DE-DE-AC-AC-DE-DE, and by applying a voltage to the pixel MP2 in the form of DE-DE-AC-AC-DE-DE-AC-AC, in addition to the first-order diffraction component of Equation 6, because a total of 16 nano-antennas NA of [AC-AC-DE-DE-AC-AC-DE-DE]-[DE-DE-AC-AC-DE-DE-AC-AC] form one period and is a repeating form, as in Equation 7, a component by $\Lambda_{SC,2}$=330 nm $\times$ 4 $\times$ 2 $\times$ 2 = 2640 nm is added. In this case, accordingly, when an emission angle (beam steering angle) of the first-order diffracted light is obtained by applying A = 1550 nm to Equation 7, as indicated by Point B in FIG. 15B, about -0.84 degrees of emission angle may be obtained.

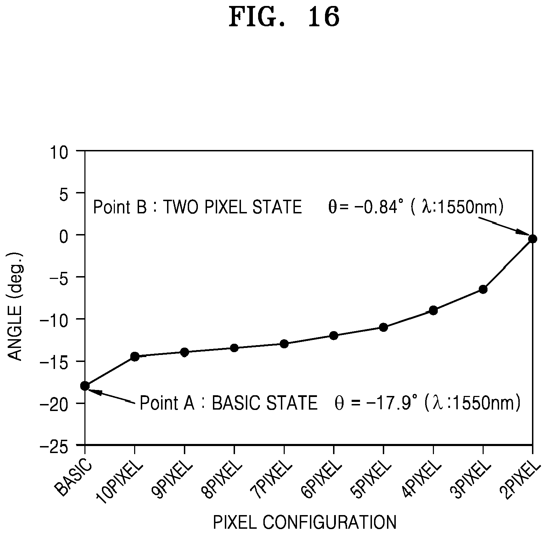

FIG. 16 shows a beam steering angle for a case when the $\Lambda_{SC,2}$ part in Equation 7 is 330 nm $\times$ 4 $\times$ 2 $\times$ N. Here, N is a natural number greater than or equal to 2, and as indicated on the horizontal axis of FIG. 16, represents the number of pixels constituting one period. The simulation conditions except for $\Lambda_{SC,2}$ applied to obtain the results of FIG. 16, are the same as those applied to obtain the results of FIGS. 15A and 15B.

Referring to FIG. 16, it may be seen that beam steering is possible for - 17.9518°, -14.0626°, -13.5814°, -12.9642°, -12.1437°, -10.9991°, -9.2903°, -6.4600°, and -0.8398° (Point B), which are intermediate angles between Point A of FIG. 15A and Point B of FIG. 15B.

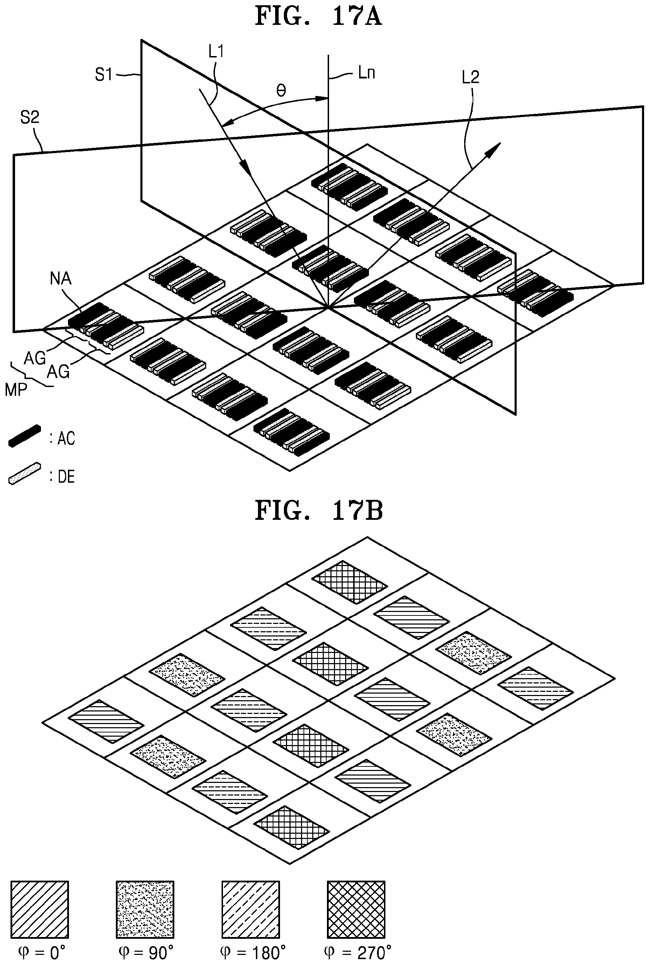

In the above, as an example, the case in which the plurality of pixels MP are one-dimensionally arranged has been described, but the plurality of pixels MP may be two-dimensionally arranged. FIGS. 17A and 17B show an example of a structure in which a plurality of pixels MP are two-dimensionally arranged. FIG. 17A exemplarily shows a two-dimensional arrangement of the plurality of pixels MP. FIG. 17B exemplarily shows a phase $\varphi$ of an effective grating MG corresponding to each of the plurality of pixels MP.

Referring to FIGS. 17A and 17B, each pixel MP includes two antenna groups AG, and each antenna group AG includes four nano-antennas NA. When a periodic and discrete driving signal is applied to the plurality of nano-antennas NA of each pixel MP, an effective grating MG is formed in each pixel MP. In FIG. 17A, nano-antennas NA indicated by a solid pattern indicate a state having strong optical intensity, and the nano-antennas NA indicated by a smooth pattern indicate a state having a weak optical strength.

Incident light L1 may be incident on the plurality of pixels MP at an incident angle of θ with respect to the normal Ln within the incident plane S1 perpendicular to the plurality of pixels MP. When phases of the effective gratings MG of all of the pixels MP are the same, the first-order diffracted light may be emitted in the normal Ln direction. When there is a phase gradient between neighboring pixels MP, two-dimensional beam steering is possible. Accordingly, if the phases of the effective gratings MG of the plurality of pixels MP are appropriately arranged, a first-order diffracted light L2 that is emitted along an emission plane S2 having an angle with respect to an incidence plane S1 and is two-dimensionally steered may be obtained.

In the example embodiment, a driving signal is applied so that the effective gratings MG of the four pixels MP belonging to each row have a geometric phase of 0 degree, 90 degrees, 180 degrees, and 360 degrees, respectively, and the effective gratings MG of the four pixels MP belonging to each column have a geometric phase of 0 degree, 90 degrees, 180 degrees, and 360 degrees, respectively. For example, the driving signal is applied to each pixel MP to have a phase difference of 90 degrees with a neighboring pixel MP. Thereby, two-dimensional beam steering is possible.

According to the distance information acquisition apparatus 1 according to an example embodiment, because a plurality of light sources 21a, 21b, and 21c emitting light of different wavelengths are applied, a plurality of beam steering angles may be obtained as many as the number of light sources.

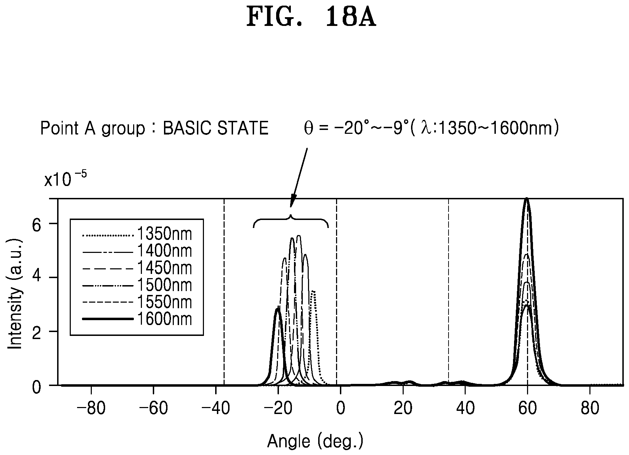

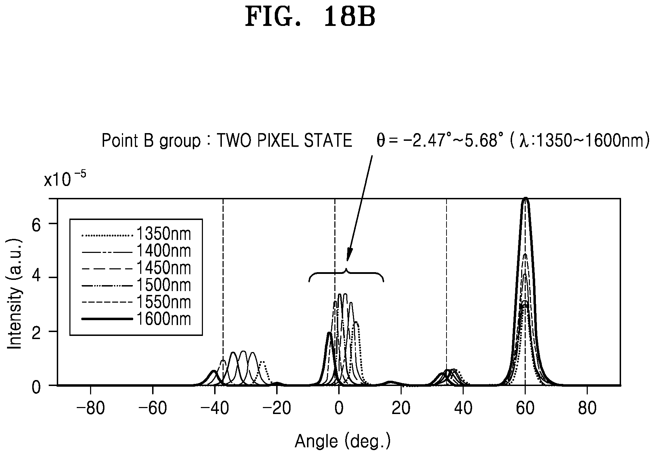

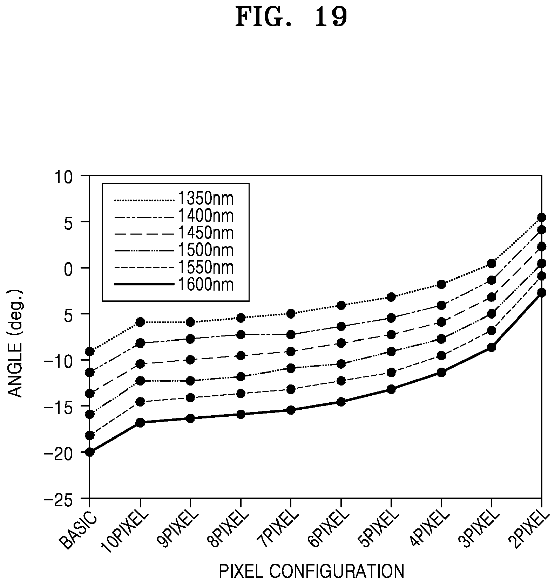

For example, as shown in Equation 7, with respect to $\Lambda_{SC}$ which is a predetermined supercell period, beam steering angles that are different from each other may be obtained for each wavelength as follows. FIGS. 18A, 18B, and 19 show beam steering angles when different wavelengths are used under the same conditions as in FIGS. 15A, 15B and 16.

FIG. 18A shows beam steering angles for wavelengths, in a case when the beam steering device has AC-AC-DE-DE-AC-AC-DE-DE pixel (MP1) and an AC-AC-DE-DE-AC-AC-DE-DE pixel (MP2) that are repeated so that the effective displacements are all the same as 0°, as shown in FIG. 15A. In this case, as the wavelength changes in Equation 6, the angle of Point A group is formed at about - 20.2487° (1600 nm wavelength), about -17.9518° (1550 nm), about -15.6844° (1500 nm), about -13.4419° (1450 nm), about -11.2202° (1400 nm) and about -9.0155° (1350 nm). That is, it is possible to secure different beam steering angles θ by applying different wavelengths to one beam steering device 100 in an optical path of 60°, which is the same incident angle.

FIG. 18B shows beam steering angles for wavelengths, in a case when a voltage is applied to the pixel MP1 in the form of AC-AC-DE-DE-AC-AC-DE-DE, and to the pixel MP2 in the form of DE-DE-AC-AC-DE-DE, as shown in FIG. 15B. In this case, as the wavelength is changed in Equation 7, the angle of Point B group is about -2.4682° (1600 nm wavelength), about -0.8398° (1550 nm), about 0.7880° (1500 nm), about 2.4164° (1450 nm) ), about 4.0468° (1400 nm), and about 5.6804° (1350 nm), and it may be seen that beam steering may be performed at the above angles.

FIG. 19 is a graph showing beam steering angles for wavelengths of 1350 nm, 1400 nm, 1450 nm, 1500 nm, 1550 nm, and 1600 nm for the case when a $\Lambda_{SC,2}$ part in Equation 7 is 330 nm $\times$ 4 $\times$ 2 $\times$ N, where N = 2 or more natural numbers. It may be seen that a plurality of different beam steering angles may be implemented by using a plurality of different wavelengths with respect to the same incident angle and the same single pixel driving method.

FIG. 19 shows examples of 60 angles of -20.2487°, -17.9518°, -16.5881°, - 16.1860°, -15.6844°, -15.6844°, -15.0413 °, -14.4482°, -14.1869°, -14.0626°, - 13.5814°, -13.4419°, -12.9960°, -12.9642°, -12.3287°, -12.1437°, -11.9587°, - 11.4969°, -11.2202°, -11.2202°, -10.9991°, -10.9043°, -10.2262°, -10.1160°, -9.8711°, -9.4278°, -9.2903°, -9.0155°, -9.0155°, -8.8586°, -8.2838°, -8.1376 °, -8.1010°, - 7.7967°, -7.3709°, -7.3709°, -7.0428°, -6.8242°, -6.4600°, -6.0961°, -6.0597°, - 5.7325°, -5.4599°, -5.3236°, -5.0785°, -4.7984°, -4.6428°, -4.0987°, -3.5549°, - 3.1201°, -2.8303°, -2.4682°, -1.6538°, -1.0207°, -0.8398°, 0.7880°, 0.7880°, 2.4164°, 4.0468°, and 5.6804° by selecting 6 types of wavelengths and using a total of 10 control types. However, more detailed angle expression is possible by further subdividing the number of different wavelengths and further subdividing the operating wavelength. In addition, the beam steering angle may be increased or decreased by configuring the nano-antennas NA in various combinations in addition to the method in which, as in the case of the FIGS. 15A, 15B and 16, 18A, 18B and 19, four nano-antennas NA are grouped as one effective grating MG and two effective gratings MG form one pixel.

FIGS. 15A, 15B, 16, 18A, 18B, and 19 show example simulation results with respect to a case when a light wave having an electric field in a direction perpendicular to the nano-antennas NA of the beam steering device 100 is incident at an angle of 60 degrees. When the incident angle of the light incident on the beam steering device 100 of the distance information acquisition apparatus 1 according to an example embodiment described with reference to FIGS. 1 and 2 is changed, the beam steering angle may be changed according to Equation 6 or Equation 7. In addition, light beams of different wavelengths emitted from the plurality of light sources 21a, 21b, and 21c may be incident on the beam steering device 100 at the same incident angle as in FIG. 1, or may be incident on the beam steering device 100 at different incident angles as shown in FIG. 2, and the beam steering angle may vary according to each wavelength of the incident light and the incident angle.

Although it has been described above that the formation and the displacement adjustment of the effective grating MG of the beam steering device 100 are achieved by electrical gating, that is, a voltage application, but embodiments are not limited thereto. The beam steering device 100 may be provided so that the formation and displacement adjustment of the effective grating MG may be achieved by any one of optical stimulation, a heating chemical reaction, a magnetic field, and mechanical methods in addition to the electrical gating.

As described above, because the distance information acquisition apparatus 1 according to an example embodiment includes the plurality of light sources 21a, 21b, and 21c emitting light of different wavelengths, and the beam steering device 100 including the plurality of nano-antennas NA and modulating a phase by displacement of the grating MG, thereby steering a traveling direction of the incident light, it is possible to emit light to a plurality of locations with respect to a control signal pattern input once, and to detect light of the plurality of locations reflected from at least one object with the plurality of photodetectors 51, 53, 55, and thus, a resolution equal to the number of light sources may increase.

In addition, according to the distance information acquisition apparatus 1 according to the example embodiment, an effective grating MG (meta grating) is formed by individually adjusting the optical intensity of the nano-antennas NA of the beam steering device 100, that is, the intensity of transmission/reflection/scattering, and displacement is induced in the optical intensity distribution of the nano-antennas NA inside a pixel MP so that a higher-order diffraction component of the incident light wave has a geometric phase proportional to the displacement. This type of beam steering device 100 may more easily adjust the displacement of the effective grating MG by digitizing and changing the optical intensity distribution of the nano-antennas NA. Accordingly, a beam may be steered at various desired angles by using the digitized control method. In addition, an amplitude of emitted light may be maintained constant within a steering range by steering the first-order diffracted light. Accordingly, excellent steering light having a small side lobe ratio may be obtained. In addition, a wiring structure for applying a driving signal to the plurality of nano-antennas NA is simple, and a linear voltage-phase response characteristic may be obtained. In addition, because the beam steering device 100 is operated in a so-called all-solid-state without a mechanical movement, a high-speed operation is possible, and a uniform response characteristic may be obtained because the dispersion of response due to an error in a manufacturing process is small.

As described above, according to the distance information acquisition apparatus 1 according to the example embodiment, a light beam may be steered by performing a phase modulation by displacement of the effective grating MG of the beam steering device 100, and also, because the light of different wavelengths emitted from the plurality of light sources 21a, 21b, and 21c may be steered at different angles, the resolution may be increased to correspond to the use of the light of the plurality of wavelengths.

Accordingly, the distance information acquisition apparatus 1 according to an example embodiment as described above may steer beams of a plurality of wavelengths at different minute angles for each wavelength, and thus, the distance information acquisition apparatus 1 may be implemented as a meta-surface Light Detection and Ranging (LiDAR) apparatus with improved resolution and frame number.

In addition, the distance information acquisition apparatus 1 according to an example embodiment may be applied to, for example, a mobile LiDAR sensor, a distance sensor, a three-dimensional sensor, etc., and accordingly, a mobile device equipped with a mobile depth camera, etc. may be implemented.

In addition, the distance information acquisition apparatus 1 according to an example embodiment may be applied to various electronic apparatuses requiring a LiDAR sensor, a distance sensor, a 3D sensor, and the like. For example, a LiDAR sensor to which the distance information acquisition apparatus 1 according to an example embodiment is applied may be applied to an autonomous vehicle, a moving object, such as a drone, a mobile device, a small walking means (e.g., bicycles, motorcycles, strollers, boards, etc.), robots, auxiliary means of humans/animals (e.g., canes, helmets, accessories, clothing, watches, bags, etc.), Internet of Things (IoT) devices/systems, security devices/systems, etc.

In addition, the distance information acquisition apparatus 1 according to an example embodiment may be applied to various systems other than the LiDAR sensor. The distance information acquisition apparatus 1 according to an example embodiment may obtain high-resolution three-dimensional information about space and an object, and thus, it may be applied to a three-dimensional (3D) image taking apparatus, a three-dimensional camera, and the like.

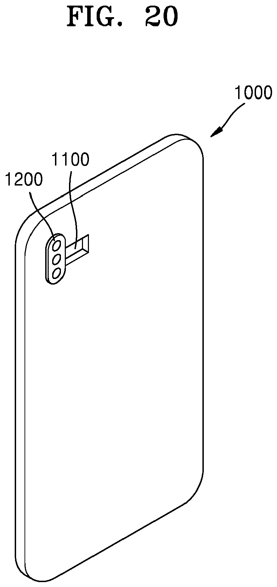

FIG. 20 is a conceptual diagram illustrating a case in which the distance information acquisition apparatus 1 according to an example embodiment is applied to a mobile device 1000. FIG. 20 shows an example of implementing a miniature depth camera that acquires a 3D image by applying a plurality of cameras 1200 and a 3D distance information acquisition apparatus 1100 on a rear of the mobile device 1000. As the 3D distance information acquisition apparatus 1100, the distance information acquisition apparatus 1 according to an example embodiment described above may be applied. After acquiring a distance information to the object to be photographed with the camera 1200 by using the 3D distance information acquisition apparatus 1100, the distance information is applied to focus adjustment of the camera or to a captured moving image or an image, such that 3D information of an object may be obtained,.

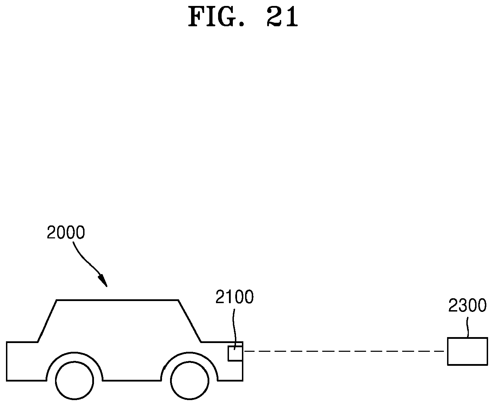

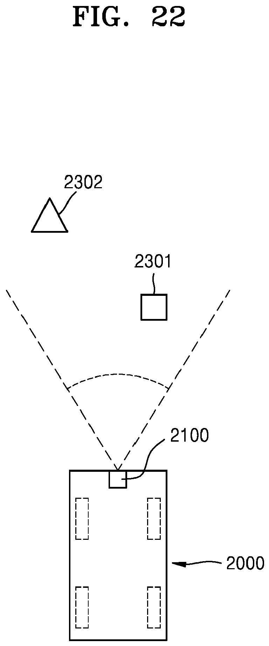

FIGS. 21 and 22 are conceptual views illustrating a case in which the distance information acquisition apparatus 1 according to an example embodiment is applied to a vehicle 2000. FIG. 21 is a diagram viewed from a side, and FIG.

22 is a diagram viewed from above.

Referring to FIG. 21, the distance information acquisition apparatus 1 according to an example embodiment may be implemented as a LiDAR device 2100 and the LiDAR device 2100 may be applied to a vehicle 2000. Information about an object 2300 may be acquired using the LiDAR device 2100. The vehicle 2000 may be a vehicle having an autonomous driving function. An object or person in a direction in which the vehicle 2000 is traveling, that is, the object 2300 may be detected by using the LiDAR device 2100. In addition, a distance to the object 2300 may be measured using information, such as a time difference between an emission signal and a detected signal. In addition, as shown in FIG. 22, information on a nearby object 2301 and a distant object 2302 within a scan range may be acquired.

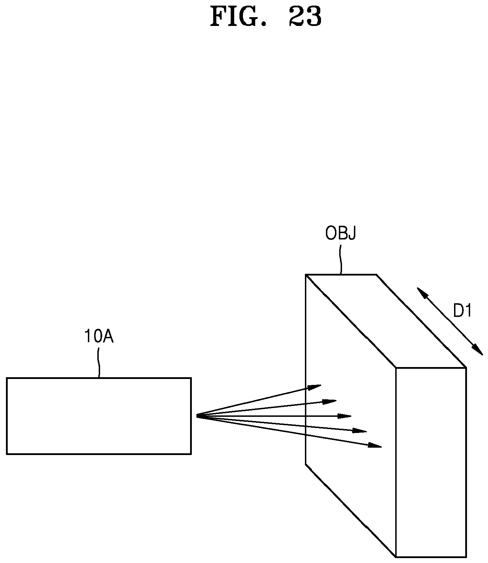

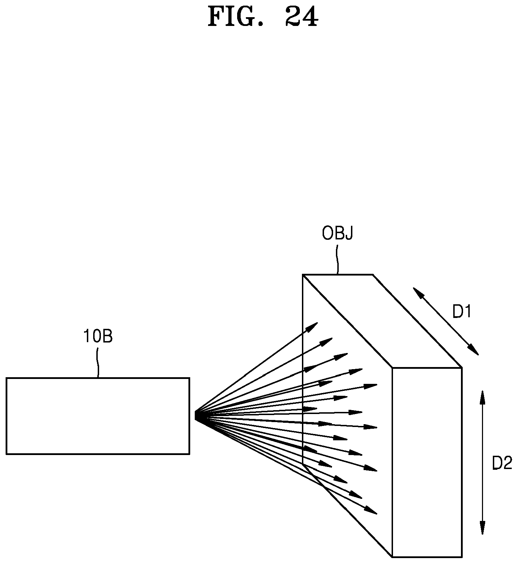

In addition, the distance information acquisition apparatus 1 according to an example embodiment may be implemented as, for example, beam steering apparatuses 10A and 10B as shown in FIGS. 23 and 24.

FIG. 23 shows the beam steering apparatus 10A to which the distance information acquisition apparatus 1 according to an example embodiment is applied.

Referring to FIG. 23, a beam may be one-dimensionally steered using the beam steering apparatus 10A. To this end, the beam steering apparatus 10A may form a one-dimensional arrangement of the effective gratings MG by configuring the beam steering device 100 of the distance information acquisition apparatus 1 to include a plurality of pixels MP that are one-dimensionally arranged. In this case, a beam may be steered toward a predetermined object OBJ in a first direction D1, and the beam steering may be performed at a different minute angle for each wavelength with respect to a plurality of wavelengths.

FIG. 24 shows a beam steering apparatus 10B to which the distance information acquisition apparatus 1 according to an example embodiment is applied.

Referring to FIG. 24, a beam may be two-dimensionally steered using the beam steering apparatus 10B. To this end, the beam steering apparatus 10B may form a two-dimensional arrangement of the effective gratings MG by configuring the beam steering device 100 of the distance information acquisition apparatus 1 to include a plurality of two-dimensionally arranged pixels MP. In this case, a beam may be two-dimensionally steered toward a predetermined object OBJ in a first direction D1 and a second direction D2 perpendicular to the first direction D1, and a beam steering may be performed at different minute angles for each wavelength with respect to a plurality of wavelengths..

The beam steering apparatuses 10A and 10B described with reference to FIGS. 23 and 24 may be non-mechanical ultrafast beam scanning apparatuses.

As in FIGS. 23 and 24, even when the beam steering devices 10A and 10B are implemented by applying the beam steering device 100 according to the example embodiment, because the beam steering device 100 steers the first-order diffracted light with reduced side lobe, a signal-to-noise ratio (SNR) of the photodetector may be improved. In addition, because there is no mechanical movement for beam steering, a high-speed operation is possible and the dispersion of response is small. Therefore, an improved precise high-speed photo-detection is possible.

The distance information acquisition apparatus 1 according to an example embodiment may be applied to various optical devices. For example, when the distance information acquisition apparatus 1 according to an example embodiment is used, a space and three-dimensional information of an object may be acquired through scanning, and thus, the distance information acquisition apparatus 1 may be applied to a three-dimensional image acquisition apparatus, a three-dimensional camera, and the like. In addition, the distance information acquisition apparatus 1 according to an example embodiment may be applied to a holographic display apparatus and a structured light generating apparatus. In addition, the distance information acquisition apparatus 1 according to an example embodiment may be applied to various optical apparatuses, such as various beam scanning devices, hologram generating devices, light coupling devices, variable focus lenses, depth sensors, etc. In addition, the distance information acquisition apparatus 1 according to an example embodiment may be applied for various purposes in various fields of optics and electronic equipment.

According to a distance information acquisition apparatus according to an example embodiment and an electronic apparatus including the same, a beam may be steered by performing phase modulation by displacement of an effective grating of a beam steering device, in addition, light of different wavelengths emitted from a plurality of light sources may be steered at different angles, and thus, a beam steering may be performed at a different minute angle for each wavelength to correspond to the use of light of a plurality of wavelengths, and resolution may be improved. The example embodiments described above are merely exemplary, and it will be understood by those skilled in the art that various changes in form and details may be made therein without departing from the scope of the present disclosure.

Accordingly, the scope of the present disclosure is defined not by the detailed description but by the appended claims and their equivalents.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims and their equivalents.

**Claims**

1.  A distance information acquisition apparatus comprising:

    a plurality of light sources configured to emit light of different wavelengths;
    a beam steering device comprising a plurality of nano-antennas, the beam steering device being configured to form an effective grating and steer a traveling direction of light incident from the plurality of light sources at an angle of incidence by modulating a phase by displacement of the effective grating;
    a plurality of photodetectors respectively corresponding to the plurality of light sources, the plurality of photo detectors being configured to detect light that is steered by the beam steering device and reflected from an object; and
    a processor configured to control the beam steering device to acquire distance information by steering a traveling direction of light.

2.  The distance information acquisition apparatus of claim 1, wherein at least two light sources from among the plurality of light sources are configured to emit light that is incident on the beam steering device at a same angle of incidence.

3.  The distance information acquisition apparatus of claim 1 or 2, wherein at least two light sources from among the plurality of light sources are configured to emit light that is incident on the beam steering device at different angles of incidence.

4.  The distance information acquisition apparatus of any preceding claim, further comprising a plurality of band-pass filters provided in front of each of the plurality of photodetectors and configured to pass a wavelength band of the emitted light of a corresponding light source among the plurality of light sources.

5.  The distance information acquisition apparatus of any preceding claim, wherein the beam steering device further comprises a reflective layer, an active layer having an optical property that changes based on a control signal, and at least one insulating layer, and
    wherein the beam steering device is further configured to form the effective grating by forming a charge accumulation region or a charge depletion region in the active layer to correspond to the plurality of nano-antennas based on a voltage applied to at least one of the plurality of nano-antennas and the reflective layer.

6.  The distance information acquisition apparatus of any preceding claim, wherein the light steered by the beam steering device is first-order diffracted light.

7.  The distance information acquisition apparatus of any preceding claim, wherein an incident angle of light emitted from one of the plurality of light sources and incident on the beam steering device is $\theta_{inc}$, an emission angle of first-order diffracted light emitted from the beam steering device is $\theta_{1st}$, a wavelength of the incident light is $\lambda_0$, a first period of the effective grating corresponding to a period of one antenna group including the plurality of nano-antennas is $\Lambda_{SC,1}$, and the emission angle of first-order diffracted light emitted from the beam steering device $\theta_{1st}$ satisfies:

$$\theta_{1st} = \sin^{-1}\left(\sin\theta_{inc} - \frac{\lambda_0}{\Lambda_{SC,1}}\right).$$

8.  The distance information acquisition apparatus of any of claims 1 to 6, wherein, an incident angle of light emitted from one of the plurality of light sources and incident on the beam steering device is $\theta_{inc}$, an emission angle of first-order diffracted light emitted from the beam steering device is $\theta_{1st}$, respectively, a wavelength of the incident light is $\lambda_0$, a first period of the effective grating corresponding to a period of one antenna group including the plurality of nano-antennas is $\Lambda_{SC,1}$, a second period of the effective grating corresponding to a period of a sum of periods of a plurality of pixels having different effective displacements from each other is $\Lambda_{SC,2}$, and the emission angle of first-order diffracted light emitted from the beam steering device $\theta_{1st}$ satisfies:

$$\theta_{1st} = \sin^{-1}\left(\sin\theta_{inc} - \frac{\lambda_0}{\Lambda_{SC,1}} + \frac{\lambda_0}{\Lambda_{SC,2}}\right).$$

9. The distance information acquisition apparatus of any preceding claim, wherein the beam steering device comprises a plurality of pixels, and each of the plurality of pixels comprises the plurality of nano-antennas, and optionally wherein each of the plurality of pixels comprises one or more antenna groups, the one or more antenna groups respectively comprises the plurality of nano-antennas, and a period of the effective grating is the same as a period of the one or more antenna groups, and further optionally wherein each of the plurality of pixels comprises two or more antenna groups, and control signals of a same pattern are applied to the two or more antenna groups included in a same pixel.

10. The distance information acquisition apparatus of claim 9, wherein the plurality of pixels have a one-dimensional array structure or a two-dimensional array structure.

11. The distance information acquisition apparatus of any preceding claim, herein the beam steering device is further configured so that the formation of the effective grating and displacement adjustment of the beam steering device are performed by any one of electrical gating, light stimulation, a heating chemical reaction, a magnetic field, and a mechanical method.

12. The distance information acquisition apparatus of any preceding claim, wherein the beam steering device is further configured to operate in regions of extreme ultraviolet, visible light, near infrared, mid-infrared, far-infrared, terahertz, THz, gigahertz, GHz, and radio frequency, RF.

13. The distance information acquisition apparatus of any preceding claim1, wherein the plurality of light sources comprises one of an edge-emitting laser, a vertical cavity surface-emitting laser, a photonic crystal surface-emitting laser, and a laser diode or a combination thereof.

14. The distance information acquisition apparatus of any preceding claim, wherein the plurality of photodetectors comprise one of silicon photomultipliers, SiPM, avalanche photodiodes, APD, single-photon avalanche photodiodes, SPAD, and a photodetector, PD.

15. An electronic apparatus comprising:

at least one sensor of a distance sensor, a three-dimensional sensor, and a Light Detection and Ranging, LiDAR, sensor,
wherein the at least one sensor comprises a distance information acquisition apparatus according to any preceding claim, and optionally wherein the sensor comprises the LiDAR sensor implemented in a mobile device, and further optionally wherein the electronic apparatus is a mobile depth camera.

# FIG. 1

1

objects

23c

23b

20

23a

61

63

65

50

51

53

55

21a

21b

21c

100

CONTROLLER —70

# FIG. 2

# FIG. 3

## FIG. 4A

$$x_1(1) = 0$$

## FIG. 4B

$$x_1(2) = \frac{\Lambda}{4}$$

## FIG. 4C

$$x_1(3) = \frac{\Lambda}{2}$$

## FIG. 4D

$$x_1(4) = \frac{3\Lambda}{4}$$

# FIG. 5

# FIG. 6

NA

214

212

211

120

V

FIG. 7

EP 4 209 802 A2

FIG. 8A    FIG. 8B    FIG. 8C    FIG. 8D    FIG. 8E

DBR

DBR

HCG

DBR

HCG

223

222

221

DBR

DBR

DBR

HCG

HCG

# FIG. 9

INCIDENT LIGHT

FIRST-ORDER
DIFFRACTED LIGHT

120

$V_1$  $V_2$  $V_3$  $V_4$  $V_5$  $V_6$

NA

214

212

211

AC

DE

# FIG. 10

# FIG. 11

φ (deg.)

# FIG. 12

1st order intensity (%)

# FIG. 13A

# FIG. 13B

# FIG. 14A

EP 4 209 802 A2

# FIG. 14B

FIRST-ORDER DIFFRACTED LIGHT

INCIDENT LIGHT

MP1

MP2

AG1 AG2 AG1 AG2

$V_a$ $V_a$ $V_d$ $V_d$ $V_a$ $V_a$ $V_d$ $V_d$ $V_d$ $V_d$ $V_a$ $V_a$ $V_d$ $V_d$ $V_a$ $V_a$

NA

214

212

211

▬ : AC

▨ : DE

EP 4 209 802 A2

# FIG. 15A

Point A : BASIC STATE    $\theta = -17.9°$ ($\lambda$ :1550nm)

# FIG. 15B

Point B : TWO PIXEL STATE    θ = −0.84° (λ:1550nm)

# FIG. 16

## FIG. 17A

: AC

: DE

## FIG. 17B

$\varphi = 0°$  $\varphi = 90°$  $\varphi = 180°$  $\varphi = 270°$

# FIG. 18A

Point A group : BASIC STATE    $\theta = -20°\sim-9°$( $\lambda$:1350~1600nm)

# FIG. 18B

Point B group : TWO PIXEL STATE    θ = −2.47°~5.68° ( λ :1350~1600nm)

# FIG. 19

# FIG. 20

# FIG. 21

# FIG. 22

# FIG. 23

# FIG. 24